# EUROPEAN PATENT SPECIFICATION

(11) **EP 4 387 427 B1**
(45) Date of publication and mention of the grant of the patent: **15.07.2026**
(21) Application number: 23215835.2
(22) Date of filing: 12.12.2023
(51) Int. Cl.: H10K 59/80, H10K 59/65

(54) **DISPLAY DEVICE**
ANZEIGEVORRICHTUNG
DISPOSITIF D'AFFICHAGE

(30) Priority: 12.12.2022 KR 20220172547
(43) Date of publication of application: 19.06.2024
(73) Proprietor: LG Display Co., Ltd., Seoul 07336 (KR)
(72) Inventor: SIN, Uisu, 10845 Paju-si, Gyeonggi-do (KR); LEE, Suyeong, 10845 Paju-si, Gyeonggi-do (KR)
(74) Representative: Viering, Jentschura & Partner mbB Patent- und Rechtsanwälte

(56) References cited:
- CN-A- 111 211 240
- CN-A- 112 447 818
- CN-A- 113 161 385
- US-A1- 2022 130 929
- US-A1- 2022 208 915
- US-B2- 11 322 564

## Description

### CROSS REFERENCE TO RELATED APPLICATION

The present application claims priority benefit to Korean Patent Application No. 10-2022-0172547, filed on December 12, 2023.

### BACKGROUND OF THE INVENTION

### Technical Field

The present invention relates to a display device, and more particularly, for example, without limitation, to a display device comprising an organic material shorting portion positioned in a non-display region thereof.

### Description of the Related Art

An organic light-emitting display device includes organic light-emitting diodes composed of a hole injection electrode, an organic light-emitting layer, and an electron injection electrode. Each organic light-emitting diode emits light based on the energy released when excitons, which are formed by the combination of electrons and holes within the organic light-emitting layer, transition from their excited state to the ground state, and the organic light-emitting display device is capable of displaying certain images using this light emission.

Unlike liquid crystal display devices, an organic light-emitting display device possesses the characteristic of self-luminance, which eliminates the need for a separate light source, allowing for reduced thickness and weight of the device. Furthermore, organic light-emitting display devices are gaining attention as the next-generation display technology due to their low power consumption, high brightness, and fast response time, among other high-quality features.

On the other hand, organic light-emitting display devices require a sealing process, using materials such as glass substrates, to encapsulate the pixels in order to protect them. However, to address the limitations posed by the thickness and weight of glass substrates, ongoing development is focused on a technology called thin film encapsulation (TFE).

The description provided in the description of the related art section should not be assumed to be prior art merely because it is mentioned in or associated with the description of the related art section. The description of the related art section may include information that describes one or more aspects of the subject technology, and the description in this section does not limit the invention.

CN 111211240 A discloses a display panel, including: a substrate including an opening region, a display region, and a first non-display region between the opening region and the display region; a plurality of display elements arranged in the display area; a thin film encapsulation layer covering the display element, the thin film encapsulation layer including an inorganic encapsulation layer and an organic encapsulation layer; a groove in the first non-display area; the planarization layer is positioned in the first non-display area and covers the groove; a first inorganic insulating layer located below the planarization layer such that the first inorganic insulating layer is located between the planarization layer and the substrate; and a second inorganic insulating layer on the planarization layer.

CN 113161385 A discloses a display device having connecting electrodes spanning the bending region. The connection electrode may be disposed on a device substrate including a bending region between the display region and the pad region. The connection electrode may connect the display region and the pad region across the bending region. The connection electrode may have a stacked structure of a lower connection electrode and an upper connection electrode. The light emitting device, the encapsulation member, and the touch electrode may be sequentially stacked on the display region of the device substrate. The upper connection electrode may include the same material as the touch electrode.

US 2022/0130929 A1 discloses a separation wall in a frame shape along a circumferential edge of a through-hole in a non-display region, in which the through-hole is formed, defined in an island shape inside a display region. The separation wall includes a wall base portion provided in a frame shape by a part of a second interlayer insulating film and a resin layer provided in an eave shape on the wall base portion to extend to a through-hole side and a display region side. Opening portions opening upward are provided on peripheries of the wall base portion on the through-hole side and the display region side in the second interlayer insulating film.

CN 112447818 A discloses a display device comprising a plurality of pixels over a substrate, the display device comprising: a pixel defining layer covering an edge of the first electrode of each of the plurality of pixels; a first spacer disposed on the pixel defining layer and including a first portion and a second portion, the first portion of the first spacer having a width that increases toward the substrate, and the second portion of the first spacer being disposed between the first portion of the first spacer and the substrate and having a width that decreases toward the substrate; and a first hole disposed apart from the first electrode between the plurality of pixels, the first hole being formed in the second portion of the first spacer and the pixel defining layer.

US 2022/0208915 A1 discloses a display device including a substrate comprising a penetration area, a separation area, at least one non-display area, and a display area; a light emitting element disposed in the display area on the substrate; at least one thin film transistor provided in the display area; a separation structure located in the separation area and disconnecting an organic light emitting layer of the light emitting element; and an unevenness pattern disposed below the separation structure and overlapping with the separation structure, wherein the unevenness pattern has a width less than a width of the separation structure.

### SUMMARY OF THE INVENTION

The inventors have recognized requirements described above. Accordingly, the present invention aims to provide a display device capable of enhancing the contact force between an undercut pattern and an organic pattern constituting an organic material shorting portion.

The objects of the present invention are not limited to the aforesaid, and other objects not described herein with be clearly understood by those skilled in the art from the descriptions below.

In order to accomplish the above objects, a display device according to claim 1 is provided. Further embodiments are described in the dependent claims. A display device according to an exemplary embodiment includes a substrate including a display area, a non-display area adjacent to the display area, and a sensor hole at least partly surrounded by the non-display area, and an organic material shorting portion positioned in the non-display area, wherein the organic material shorting portion includes an undercut pattern, an organic pattern positioned on the undercut pattern and larger in width than the undercut pattern, and an inorganic pattern positioned between the undercut pattern and the organic pattern and smaller in width than the undercut pattern.

An upper surface and side surfaces of the inorganic pattern contacts the organic pattern.

The inorganic pattern exposes an upper surface of the undercut pattern partially, and the organic pattern contacts the upper surface of the exposed undercut pattern directly.

The inorganic pattern contacts a central portion of the upper surface of the undercut pattern and exposes a remaining portion of the upper surface of the undercut pattern.

The display device may further comprise an organic light-emitting device positioned in the display area of the substrate.

The organic light-emitting device may comprise an anode electrode on the substrate, an organic layer on the anode electrode, and a cathode electrode on the organic layer.

The organic layer may include first organic layers contacting side surfaces of undercut pattern and a second organic layer contacting an upper surface and side surfaces of the organic pattern.

The first organic layers and second organic layer may be shorted by the organic material shorting portion.

The organic layer may be positioned in the non-display area and shorted by the organic material shorting portion.

The organic layer may be positioned on upper and side surfaces of the organic pattern.

The display device may further comprise an encapsulation layer on the organic light-emitting device, wherein the encapsulation layer comprises a first inorganic film, an organic film on the first inorganic film, and a second inorganic film.

The non-display area may comprise an area in which the organic material shorting portion is provided and a dam area adjacent to the area.

The organic material shorting portion may be provided in multiple quantities and the multiple organic material shorting portions may comprise a first organic material shorting portion between the display area and the dam area and a second organic shorting material portion between the dam area and the sensor hole.

The organic layer may be positioned outside the dam area in a planar view, and the first inorganic film and the second inorganic film may contact each other in the dam area and the second organic material shorting portion.

The first inorganic film may directly contact the upper and side surfaces of the organic pattern.

The first inorganic film may directly contact a side surface of the undercut pattern and a lower surface of the organic pattern.

The inorganic pattern may directly contact an upper surface of the undercut pattern.

The undercut pattern may comprise a plurality of layers. In order to accomplish the above objects, a display device according to another embodiment includes a substrate including a display area, a non-display area adjacent to the display area, and a sensor hole surrounded by the non-display area, all defined thereon, and an organic material shorting portion positioned in the non-display area, wherein the organic material shorting portion includes an undercut pattern, an organic pattern positioned on the undercut pattern and larger in width than the undercut pattern, the undercut pattern includes an opening penetrating the undercut pattern from an upper surface thereof, and the organic pattern fills the opening.

The organic pattern may directly contact the undercut pattern within the opening.

The display device may further comprise an organic light-emitting device positioned in the display area.

The organic light-emitting device may comprise an anode electrode on the substrate, an organic layer on the anode electrode, and a cathode electrode on the organic layer.

The organic layer may include first organic layers contacting side surfaces of undercut pattern and a second organic layer contacting an upper surface and side surfaces of the organic pattern.

The first organic layers and second organic layer may be shorted by the organic material shorting portion.

The display device may further comprise at least one inorganic layer between the undercut pattern and the substrate, wherein the opening penetrates the at least one inorganic layer and the organic pattern contact the at least one inorganic layer within the opening.

The undercut pattern may comprise a plurality of layers.

The organic material shorting portion may further comprise an inorganic pattern between the undercut pattern and the organic pattern.

The inorganic pattern may be smaller in width than the undercut pattern.

The inorganic pattern may be larger in width than the opening.

The inorganic pattern may be positioned on an upper surface of the undercut pattern outside the opening and within the opening.

The inorganic pattern may contact a side surface of the undercut pattern within the opening.

The detailed descriptions of other embodiments are included in the specifications and drawings.

According to the embodiments, a display device is capable of being fabricated with an enhanced contact force between the undercut pattern and the organic pattern. As a result, the structural reliability of the organic material shorting portion can be improved.

The advantages according to the embodiments are not limited to the aforesaid, and a variety of other advantages are included within the specification.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a display device according to an exemplary embodiment of the present disclosure;
FIG. 2 is an enlarged view of area A in FIG. 1;
FIG. 3 is an enlarged view of area B in FIG. 2;
FIG. 4 is a cross-sectional view taken along the line I-I' in FIG. 3;
FIG. 5A is a plan view of a second-2 non-display area according to an exemplary embodiment of the present disclosure;
FIG. 5B is a plan view of a second-2 non-display area according to an alternative embodiment of the present disclosure;
FIG. 6 is a cross-sectional view taken along the line II-II' in FIG. 5A;
FIG. 7 is a cross-sectional view taken along the line III-III' in FIG. 5A;
FIGS. 8 to 9 are cross-sectional views illustrating process steps of a method for fabricating an organic material shorting portion according to an exemplary embodiment of the present disclosure;
FIG. 10 is a cross-sectional view of organic material shorting portion according to another embodiment of the present disclosure;
FIG. 11 is a cross-sectional view of an organic material shorting portion according to another embodiment of the present disclosure;
FIG. 12 is a cross-sectional view of an organic material shorting portion according to another embodiment of the present disclosure;
FIG. 13 is a cross-sectional view of an organic material shorting portion according to another embodiment of the present disclosure;
FIG. 14 is a cross-sectional view of an organic material shorting portion according to another embodiment of the present disclosure;
FIG. 15 is a cross-sectional view of an organic material shorting portion according to another embodiment of the present disclosure;
FIG. 16 is a cross-sectional view of an organic material shorting portion according to another embodiment of the present disclosure;
FIG. 17 is a cross-sectional view of an organic material shorting portion according to another embodiment of the present disclosure;
FIG. 18 is a cross-sectional view of an organic material shorting portion according to another embodiment of the present disclosure;
FIG. 19 is a cross-sectional view of an organic material shorting portion according to another embodiment of the present disclosure;
FIG. 20 is a cross-sectional view of an organic material shorting portion according to another embodiment of the present disclosure;
FIG. 21 is a cross-sectional view of an organic material shorting portion according to another embodiment of the present disclosure;
FIG. 22 is a cross-sectional view of a display area, second non-display area, dam area, and sensor hole according to another embodiment of the present disclosure;
FIG. 23 is a cross-sectional view of the organic material shorting portion in FIG. 22;
FIG. 24 is a cross-sectional view of an organic material shorting portion according to another embodiment of the present disclosure;
FIG. 25 is a cross-sectional view of an organic material shorting portion according to another embodiment of the present disclosure; and
FIG. 26 is a cross-sectional view of an organic material shorting portion according to another embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE INVENTION

Advantages and features of the present invention and methods of accomplishing the same may be understood more readily by reference to the following detailed description of embodiments and the accompanying drawings. The present invention may, however, be embodied in many different forms and should not be construed as being limited to the exemplary embodiments set forth herein; rather, these exemplary embodiments are provided so that the present invention will be thorough and complete and will fully convey the concept of the invention to those skilled in the art, and the present invention will only be defined by the appended claims.

When it is mentioned that one device or layer is located on another device or layer, it may be understood that one device or layer is directly located on the other device or layer or that still other device or layer is interposed between the two devices or layers. Throughout the specification, the same reference numerals refer to the same components. The shapes, sizes, areas, ratios, angles, numbers and the like disclosed in the drawings to describe embodiments of the present invention are merely exemplary, and thus, the present invention is not limited thereto.

The terms such as "include," "have," "comprise," "contain," "constitute," "make up of," "formed of," and "consist of" used herein are generally intended to allow other elements to be added unless the terms are used with the term such as "only". Any references to singular may include plural unless expressly stated otherwise.

Elements are interpreted to include an ordinary error range or an ordinary tolerance range even if not expressly stated.

When the position relation between two parts is described using the terms such as "on", "above", "over", "below", "under", "beside", "beneath", "near", "close to," "adjacent to", "on a side of", "next" or the like, one or more parts may be positioned between the two parts unless the terms are used with the term such as "immediately" or "directly".

Spatially relative terms, such as "under," "below," "beneath", "lower," "over," "upper" and the like, may be used herein for ease of description to describe one element or feature's relationship to another element(s) or feature(s) as illustrated in the figures. It will be understood that the spatially relative terms can encompass different orientations of an element in use or operation in addition to the orientation depicted in the figures. For example, if an element in the figures is inverted, elements described as "below" or "beneath" other elements or features would then be oriented "over" the other elements or features. Thus, the exemplary term "below" can encompass both an orientation of below and above. Similarly, the exemplary term "above" or "over" can encompass both an orientation of "above" and "below".

In describing temporal relationship, terms such as "after," "subsequent to," "following," "next," "before," and the like may include cases where any two events are not consecutive, unless the term such as "immediately" "just" or "directly" is explicitly used.

In describing elements, terms such as "first", "second", "A", "B", "(a)", "(b)" or the like are used, but the elements are not limited by these terms. These terms are simply used to distinguish one element from another. Accordingly, as used herein, a first element may be a second element within the technical idea of the present disclosure.

Although the terms such as "first", "second", "A","B","(a)", "(b)" and the like are used for describing various components, these components are not confined by these terms. These terms are merely used for distinguishing one component from the other components. Accordingly, a first component mentioned earlier may also be a second component within the technical spirit of the present invention.

In the case that it is described that a certain structural element or layer is "connected", "coupled", "adhered" or "joined" to another structural element or layer, it is typically interpreted that another structural element or layer may be "connected", "coupled", "adhered" or "joined" to the structural element or layer directly or indirectly.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

A term "device" used herein may refer to a display device including a display panel and a driver for driving the display panel. Examples of the display device may include an organic light-emitting device, an inorganic light-emitting device, liquid crystal device and the like. In addition, examples of the device may include a notebook computer, a television, a computer monitor, an automotive device, a wearable device, and an automotive equipment device, and a set electronic device (or apparatus) or a set device (or apparatus), for example, a mobile electronic device such as a smartphone or an electronic pad, which are complete products or final products respectively including an organic light-emitting device, an inorganic light-emitting device, liquid crystal device and the like, but embodiments of the present disclosure are not limited thereto.

A size and a thickness of each component illustrated in the drawing are illustrated for convenience of description, and the present disclosure is not limited to the size and the thickness of the component illustrated.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein.

In the aspects of the present disclosure, a source electrode and a drain electrode are distinguished from each other, for convenience of description. However, the source electrode and the drain electrode are used interchangeably. The source electrode may be the drain electrode, and the drain electrode may be the source electrode. Also, the source electrode in any one aspect of the present disclosure may be the drain electrode in another aspect of the present disclosure, and the drain electrode in any one aspect of the present disclosure may be the source electrode in another aspect of the present disclosure.

The various features of the embodiments of the present invention can combined or assembled together, either partially or entirely, in a technically diverse manner, and each embodiment can be independently implemented or in conjunction with related embodiments.

Hereinafter, exemplary embodiments of the present invention will be described in detail with reference to accompanying drawings.

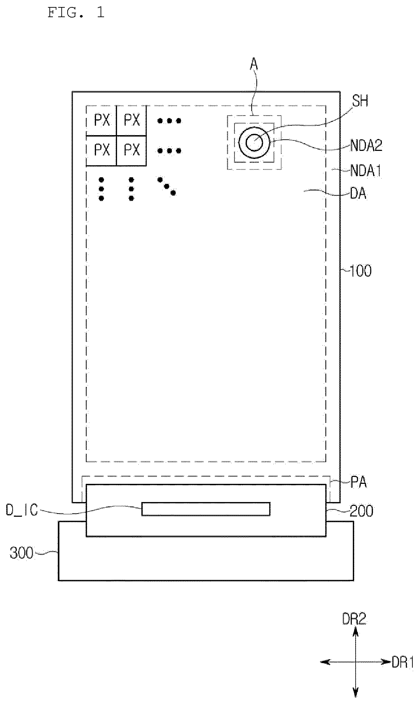

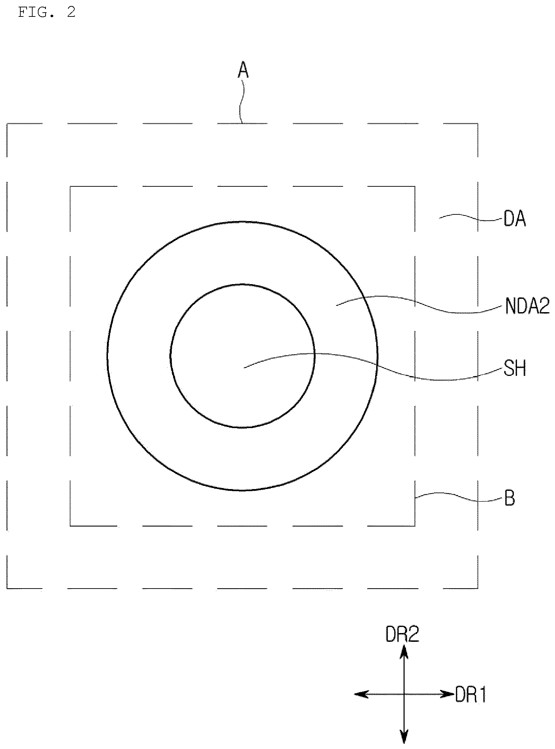

FIG. 1 is a plan view of a display device according to an exemplary embodiment of the present disclosure, FIG. 2 is an enlarged view of area A in FIG. 1. All the components of each display device according to all embodiments of the present disclosure are operatively coupled and configured.

With reference to FIGS. 1 and 2, the display device according to an exemplary embodiment of the present disclosure may be an organic light-emitting display device, but is not limited thereto and may also be a liquid crystal display device or an inorganic light-emitting display device. The following description will primarily focus on the cases where the display device is embodied in an organic light-emitting display device. The organic light-emitting display device may include a display panel 100. The display panel 100 may include a display area DA, a first non-display area NDA1 disposed in the vicinity of the display area DA or surrounding the display area DA, and a second non-display area NDA2 surrounded by the display area DA. The display area DA and non-display areas NDA1 and NDA2 may each be defined on the substrate 101 to be described later. Meanwhile, the display panel 100 may further include a sensor hole SH surrounded by the second non-display area NDA2. The sensor hole SH may be completely surrounded by the second non-display area NDA2 in the planar view. The sensor hole SH may accommodate the placement of a sensor. The sensor may be a camera sensor, but is not limited thereto and may also include various sensors known in the technical field, such as infrared sensors. Although FIG. 1 shows a one sensor hole SH, the sensor hole SH is not limited to one, and may also be provided in multiple quantities. Although the sensor hole SH is disposed on the upper side of the display panel 100 as shown in Fig. 1, the present disclosure is not limited thereto, one or more sensor hole SH may be located in any position of the display panel 100.

The display area DA may include a plurality of pixels PX. The plurality of pixels PX may be arranged in a matrix array format. The display area DA may have a rectangular shape including long sides extended in a first direction DR1 and short sides extended in a second direction DR2 perpendicular to the first direction DR1, but is not limited thereto, for example, the display area DA may have a square shape in which a length of the long side is same to a length of the short side, or the display area DA may also have other shapes.

The first non-display area NDA1 may surround or be in the vicinity of the display area DA in a planar view. The first non-display area NDA1 may include a pad area PA. The pad area PA may be positioned on at least one end of the opposite ends of the display panel 100 in the second direction DR2. However, the configuration is not limited thereto.

A chip-on-film 200 may be attached to the pad area PA. A driving chip D_IC may be mounted on the chip-on-film 200. A printed circuit board 300 may be attached to any one end of the opposite ends of the chip-on-film 200 in the second direction DR2. Although FIG. 1 shows an example where the driving chip D_IC is mounted on the chip-on-film 200, the configuration is not limited thereto, and the driving chip D_IC may also be directly mounted on the display panel 100. For example, the driving chip D_IC may be mounted on the printed circuit board PCB in a form of a chip on board (COB). Although in FIG. 1, it is illustrated that the driving chip D_IC is mounted in a chip on film(COF) manner, driving chip D_IC may be mounted in a method such as a chip on board (COB) method, a chip on glass (COG) method, a tape carrier package (TCP) method, or the like, and the present disclosure is not limited thereto.

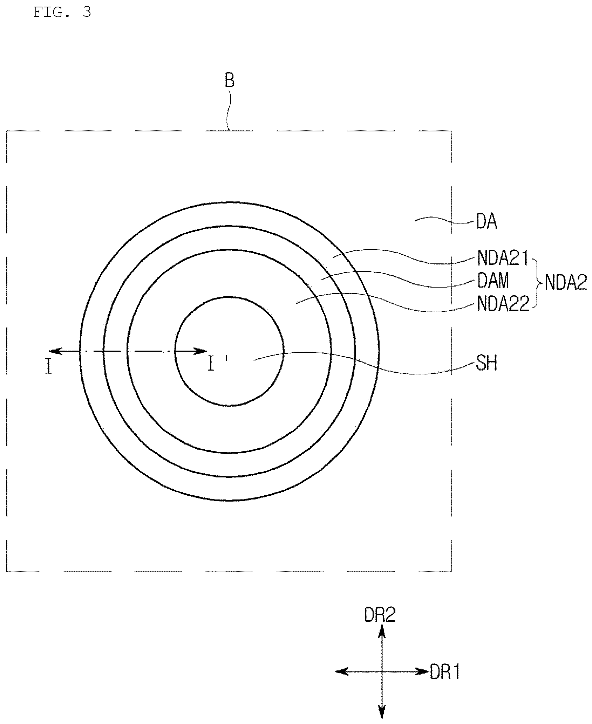

FIG. 3 is an enlarged view of area B in FIG. 2.

With reference to FIG. 3, the second non-display area NDA2 may include a second-1 non-display area NDA21 surrounded by the display area DA, a dam area with a dam DAM surrounded by the second-1 non-display area NDA21, and a second-2 non-display area NDA22 surrounded by the dam area (or dam DAM). The second-2 non-display area NDA22 may completely surround the sensor hole SH.

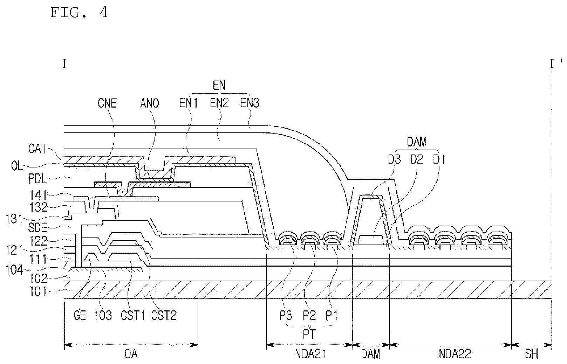

FIG. 4 is a cross-sectional view taken along line I-I' of FIG. 3.

With reference to FIGS. 1 to 4, the display panel (100 in FIG. 1) may include a substrate 101, a buffer layer 102 on the substrate 101, a semiconductor layer 103 on the buffer layer 102, a gate insulating layer 104 on the semiconductor layer 103, a first conductive layer 110 (for example, a first gate electrode GE and a first electrode CST1 of a storage capacitor) on the gate insulating layer 104, a first interlayer insulating layer 111 on the first conductive layer 110, a second conductive layer 120 (for example, a second electrode CST2 of the storage capacitor) on the first interlayer insulating layer 111, a second-1 interlayer insulating layer 121 on the second conductive layer 120, a second-2 interlayer insulating layer 122 on the second-1 interlayer insulating layer 121, a third conductive layer 130 (for example, a source electrode SDE) on the second-2 interlayer insulating layer 122, a passivation layer 131 on the third conductive layer 130, a first planarization layer 132 on the passivation layer 131, a fourth conductive layer 140 (for example, a connection electrode CNE) on the first planarization layer 132, a second planarization layer 141 on the fourth conductive layer 140, an anode electrode ANO on the second planarization layer 141, a pixel definition layer PDL on the anode electrode ANO, an organic layer OL on the pixel defining layer PDL, a cathode electrode CAT on the organic layer OL, and an encapsulation layer EN on the cathode electrode CAT.

The substrate 101 may support each layer that is placed on top thereof. The substrate 101 may be positioned across the display area DA and non-display areas NDA1 and NDA2. The substrate 101 may be composed of insulating materials such as polymer resin. Examples of the polymer resin include polyethersulfone (PES), polyacrylate (PA), polyarylate (PAR), polyetherimide (PEI), polyethylene napthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or combinations thereof. The substrate 101 may be a flexible substrate capable of bending, folding, rolling, and the like. Examples of materials constituting a flexible substrate may include any one of polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), cyclic olefin copolymer(COC), triacetylcellulose(TAC), polyvinyl alcohol(PVA), and polystyrene(PS), but are not limited thereto. The substrate 101 may also be a rigid substrate made of materials such as glass, quartz, and the like.

The buffer layer 102 may be disposed on the substrate 101. The buffer layer 102 may be positioned across the entire display area DA and non-display areas NDA1 and NDA2. However, the buffer layer 102 may not be formed over the sensor hole SH. The buffer layer 102 serves to protect various components of the display device 100 and prevent the diffusion of impurity ions and to inhibit the penetration of moisture and external substances.

In FIG. 4, the buffer layer 102 is shown as single layer, but the present disclosure is not limited thereto, for example , the buffer layer 102 may consist of a plurality of layers. For example, the buffer layer 102 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto. Alternatively, the buffer layer 102 may be omitted depending on a structure or characteristics of the display panel 100.

The first semiconductor layer 103 may be positioned on the buffer layer 102. The first semiconductor layer 103 may include polycrystalline silicon. The polycrystalline semiconductor material has a fast movement speed of carriers such as electrons and holes and thus has high mobility, and has low energy power consumption and superior reliability. The polycrystalline semiconductor may be made of polysilicon, but is not limited thereto. The first semiconductor layer 103 may have a channel region, source region, and drain region. Polycrystalline silicon may be formed by crystallizing amorphous silicon. Examples of crystallization methods include rapid thermal annealing (RTA), solid phase crystallization (SPC), excimer laser annealing (ELA), metal-induced crystallization (MIC), metal-induced lateral crystallization (MILC), sequential lateral solidification (SLS), Molecular Beam Epitaxy (MBE), Liquid Phase Epitaxy (LPE), Hydride Vapor Phase Epitaxy (HVPE), and the like, but are not limited thereto. The first semiconductor layer 103 may be oxide semiconductor material or amorphous semiconductor material, in addition to the polycrystalline semiconductor.

The gate insulating layer 104 may be positioned on the first semiconductor layer 103. The gate insulating layer 104 is positioned across the display area DA and the non-display areas NDA1 and NDA2, except for the sensor hole SH. The gate insulating layer 104 may serve as a gate insulating film for insulating the first semiconductor layer 103 and gate electrode GE from each other. The gate insulating layer 104 may include silicon compounds, metal oxides, and the like. For example, the gate insulating layer 104 may include silicon oxide, silicon nitride, silicon oxynitride, aluminum oxide, tantalum oxide, hafnium oxide, zirconium oxide, titanium oxide, and the like, but not limited thereto. These materials may be used individually or in combination with each other. Although the gate insulating layer 104 is depicted as a single layer in the drawing, in some cases, the gate insulating layer 104 may be a multilayer film composed of stacked layers of different materials. Although FIG. 4 illustrates a structure in which the gate insulating layer 104 is disposed on the entire first semiconductor layer 103, the present disclosure is not limited thereto. Alternatively, the gate insulating film 304 may be disposed on a portion of the top surface of the first semiconductor layer 103.

The first conductive layer 110 may be positioned on the gate insulating layer 104.

In an exemplary embodiment, the first conductive layer 110 may include the first gate electrode GE and the first electrode CST1 of a storage capacitor. Additionally, the first conductive layer 110 may also include a scanning signal line for transmitting scanning signals to the first gate electrode GE, but not limited thereto. The first gate electrode GE may be arranged to overlap with the channel region of the first semiconductor layer 103.

The first gate electrode GE and the first electrode CST1 of the storage capacitor may be formed of the same material in the same process. For example, the first conductive layer 110 may include one or more selected metals from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu) , or alloys thereof. Additionally, although the first conductive layer 110 is depicted as a single layer, the first conductive layer 110 may be formed as a multilayer film in some cases. In this case, the multilayer film of the first conductive layer 110 may be formed by stacking layers of different metals as mentioned above.

A first interlayer insulating layer 111 may be positioned on the first conductive layer 110 . The first interlayer insulating layer 111 may be positioned across the display area DA and the non-display area NDA, excluding the pad area PA.

The first interlayer insulating layer 111 may provide insulation between the first conductive layer 110 and the second conductive layer 120. The first interlayer insulating layer 111 may serve as an interlayer insulating film.

The first interlayer insulating layer 111 may include inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like. Although the first interlayer insulating layer 111 is depicted as a single layer in the drawing, but it is not limited thereto and the first interlayer insulating layer 111 may be a multilayer film composed of stacked layers of different materials.

The second conductive layer 120 may be positioned on the first interlayer insulating layer 111. The second conductive layer 120 may include the second electrode CST2 of a storage capacitor. The second electrode CST2 may overlap with the first electrode CST1 with the first interlayer insulating layer 111 therebetween. That is, the first electrode CST1 and the second electrode CST2 may form a storage capacitor Cst with the first interlayer insulating layer 111 serving as a dielectric film.

The second conductive layer 120 may include one or more metals selected from molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu) , or alloys thereof. In an exemplary embodiment, the second conductive layer 120 may be composed of the same or different material as the first conductive layer 110.

Although the second conductive layer 120 is depicted as a single layer in the drawing, it may also be formed as a multilayer film in some cases, for example, the multilayer film of the second conductive layer 120 may be formed by stacking layers of different metals as mentioned above.

On the second conductive layer 120, the second interlayer insulating layers 121 and 122 are positioned. The second interlayer insulating layers 121 and 122 may insulate the second conductive layer 120 from the third conductive layer 130.

The second interlayer insulating layers 121 and 122 may include inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like, but not limited thereto.

The second interlayer insulating layers 121 and 122 generally cover the second conductive layer 120 in the display area DA and may also be positioned in the non-display areas NDA1 and NDA2. The second interlayer insulating layers 121 and 122 may include a second-1 interlayer insulating layer 121 and a second-2 interlayer insulating layer 122. For example, the second-1 interlayer insulating layer 121 may include silicon oxide, and the second-2 interlayer insulating layer 122 may include silicon nitride, and the present disclosure is not limited thereto. For example, the second-1 interlayer insulating layer 121 may include any one of inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like, and the second-2 interlayer insulating layer 122 may include any one of inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like, and the second-1 interlayer insulating layer 121 and the second-2 interlayer insulating layer 122 may be made of different materials.

The second-2 interlayer insulating layer 122 may form an undercut pattern P1 of organic material shorting portion PT in the second-1 non-display area NDA21 and the second-2 non-display area NDA22. The organic material shorting portion PT may be provided in multiple quantities. The plurality of organic material shorting portions PT may be placed in the respective second-1 non-display area NDA21 and second-2 non-display area NDA22, and adjacent organic material shorting portions PT may be arranged to be spaced apart from each other. The second-2 interlayer insulating layer 122 may form the first dam portion D1 of the dam DAM in the dam area.

The third conductive layer 130 may be positioned on the second interlayer insulating layers 121 and 122.

In an exemplary embodiment, the third conductive layer 130 may include a source electrode SDE. The source electrode SDE may be connected to the source region of the first semiconductor layer 103. Although not shown in the drawing, the third conductive layer 130 may also include a drain electrode connected to the drain region of the first semiconductor layer 103 and other components.

The third conductive layer (130) may include one or more selected metals among aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo) or alloys thereof. The third conductive layer 130 may be a single layer as depicted in the drawing. However, without being limited thereto, the third conductive layer 130 may be a multilayer. For example, the third conductive layer 130 may be formed with a stacked structure such as Ti/Al/Ti, Mo/Al/Mo, Mo/AlGe/Mo, Ti/Cu, and so on.

A passivation layer 131 may be disposed on the third conductive layer 130. The passivation layer 131 may include inorganic insulating materials such as silicon oxide, silicon nitride, silicon oxynitride, hafnium oxide, aluminum oxide, titanium oxide, tantalum oxide, zinc oxide, and so on.

The passivation layer 131 may be arranged in the display area DA, the first non-display area NDA1 and the second non-display area NDA2, specifically in the second-1 non-display area NDA21 and the second-2 non-display area NDA22 among the second non-display area NDA2. The passivation layer 131 may form the inorganic pattern P2 of organic material shorting portion PT in the second-1 non-display area NDA21 and the second-2 non-display area NDA22. The width of the inorganic pattern P2 may be smaller than the width of the underlying undercut patterns P1. The inorganic pattern P2 may be directly positioned on the undercut pattern P1. The passivation layer 131 may protect components under the passivation layer 131 from moisture and oxygen. The passivation layer 131 may be formed as a single layer or multiple layers, but is not limited thereto.

The first planarization layer 132 may be disposed on the passivation layer 131. The first planarization layer 132 may include organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like. The first planarization layer 132 may be formed as a single layer or a plurality of layers and may also be referred to as an organic insulating layer.

The first planarization layer 132 may be positioned in the display area DA, except for the second non-display area NDA2 and the sensor hole SH.

The fourth conductive layer 140 may be positioned on the first planarization layer 132. The fourth conductive layer 140 may include connection electrode CNE. The connection electrode CNE may be connected to the source electrode SDE mentioned earlier by penetrating through the first planarization layer 132 and the passivation layer 131. For example, connection electrode CNE may be connected to the source electrode SDE through contact holes provided in the first planarization layer 132 and the passivation layer 131, but not limited thereto.

The fourth conductive layer 140 may include one or more metals selected from aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), molybdenum (Mo) or alloy thereof. The fourth conductive layer 140 may be a single layer as depicted in the drawing. However, it is not limited thereto, and the fourth conductive layer 140 may be a multilayer. For example, the fourth conductive layer 140 may be formed with a stacked structure such as Ti/Al/Ti, Mo/Al/Mo, Mo/AlGe/Mo, Ti/Cu, and so on.

The second planarization layer 141 may be positioned on the fourth conductive layer 140. The second planarization layer 141 may include organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like. The second planarization layer 141 may be formed as a single layer or a plurality of layers.

The second planarization layer 141 may be positioned in the display area DA and the second non-display area NDA2. The second planarization layer 141 may form organic pattems P3 of the organic material shorting portion PT in the second-1 non-display area NDA21 and the second-2 non-display area NDA22, and it may form a second dam portion D2 of the dam DAM in the dam area. The width of the organic pattern P3 may be larger than the width of the undercut pattern P1. The organic pattern P3 covers the top and sides of the inorganic pattern P2 and comes into contact with their top and side surfaces. The inorganic pattern P2 partially exposes the top surface of the undercut pattems P1. That is, the inorganic pattern P2 covers the central portion of the top surface of the undercut pattern P1, while leaving the surrounding area exposed. The organic pattern P3 directly contacts the top surface of the outer periphery of the undercut pattern P1 exposed by the inorganic pattern P2. The central portion of the bottom surface of the organic pattern P3 may be covered by both the inorganic pattern P2 and the undercut pattern P1, while the outer periphery of the bottom surface may be exposed.

The width of the second dam portion D2 may be smaller than the width of the first dam portion D1, the configuration is not limited thereto.

The anode electrode ANO may be positioned on the second planarization layer 141. The anode electrode ANO may be connected to connection electrodes CNE through the second planarization layer 141, for example, the anode electrode ANO may be connected to connection electrodes CNE through contact holes provided in the second planarization layer 141, and further connected to the source electrode SDE through the connection electrodes CNE. In addition, the anode electrode ANO may have a multilayer structure, and may comprise a metal material such as Au, W, Pt, Si, Ir, Ag, Cu, Ni, Ti, or Cr, and an alloy thereof. Alternatively, the anode electrode ANO may include a transparent conductive material such as ITO indium tin oxide or IZO indium zinc oxide.

The pixel definition layer PDL may be positioned on anode electrode ANO. The pixel definition layer PDL may include an opening exposing the anode electrode ANO. The pixel definition layer PDL may be made of organic insulating materials or inorganic insulating materials. For example, the pixel definition layer PDL may include materials such as photoresist, polyimide resin, acrylic resin, silicon compounds, polyacrylic resin and the like.

The organic layer OL may be positioned on the top surface of the anode electrode ANO and within the openings of the pixel definition layer PDL. Although the organic layer OL is positioned within the opening of the pixel definition layer PDL in the drawing, it is not limited thereto, and the organic layer OL may extend from the opening of the pixel definition layer PDL to the top surface of the pixel definition layer PDL.

The organic layer OL may include an organic light-emitting layer, hole injection/transport layers, and electron injection/transport layers. For example, the organic layer OL may be formed by stacking one or more of hole injection and transport layers, an organic light-emitting layer, and one or more of electron injection and transport layers on the anode electrode ANO in the order thereof.

The organic layer OL may be positioned in the display area DA and the second non-display area NDA2. The organic layer OL may be continuous in the display area DA and the dam area and discontinuous in the second-1 non-display area NDA21 and the second-2 non-display area NDA22. That is, the organic layer OL may be shorted by organic material shorting portion PT in the second-1 non-display area NDA21 and the second-2 non-display area NDA22.

A cathode electrode CAT is positioned on the organic layer OL and the pixel definition layer PDL. The cathode electrode CAT may serve as a common electrode positioned across multiple pixels PX in the display area DA. The organic layer OL, anode electrode ANO, and cathode electrode CAT may form an organic light-emitting diode OLED. In addition, the cathode electrode CAT may have a multilayer structure, and may comprise a metal material such as Au, W, Pt, Si, Ir, Ag, Cu, Ni, Ti, or Cr, and an alloy thereof. Alternatively, the cathode electrode CAT may include a transparent conductive material such as ITO indium tin oxide or IZO indium zinc oxide.

An encapsulation layer EN is positioned on the cathode electrode CAT. The encapsulation layer EN may cover the OLED. The encapsulation layer EN may be a stacked film composed of alternating inorganic and organic layers. For example, the encapsulation layer EN may include sequentially stacked first inorganic film EN1, an organic film EN2, and second inorganic film EN3. The first inorganic film EN1, the organic film EN2, and the second inorganic film EN3 may be positioned across the display area DA and the second-1 non-display area NDA21. However, the organic film EN2 may not be positioned on the inner side (that is, second-2 non-display area NDA22 and sensor hole SH) of the dam DAM by the dam DAM. Accordingly, the first inorganic film EN1 and the second inorganic film EN3 may directly contact each other without the organic film EN2 in the area of the dam DAM and in the second-2 non-display area NDA22.

The encapsulation layer EN may include a plurality of encapsulating layers including at least one inorganic encapsulating layer, and at least one organic encapsulating layer. For example, the encapsulation layer EN may have a structure in which at least one organic encapsulating layer is disposed between inorganic encapsulating layers. The uppermost layer of the encapsulation layer EN may be the inorganic encapsulating layer. Thus, in the display apparatus according to the embodiment of the present disclosure, the penetration of the external moisture and oxygen may be effectively blocked or at least reduced.

Meanwhile, the encapsulation layer EN is not limited to three layers, for example, the encapsulation layer EN may include n layers alternately stacked between inorganic layer and organic layer (where n is an integer greater than 3).

As described above, there may be no upper stacked structure other than the substrate 101 in the area of the sensor hole SH. However, the configuration is not limited thereto, and a buffer layer 102 may also be positioned in the area of the sensor hole SH.

Hereinafter, a more detailed description will be provided for the organic material shorting portion PT according to an exemplary embodiment.

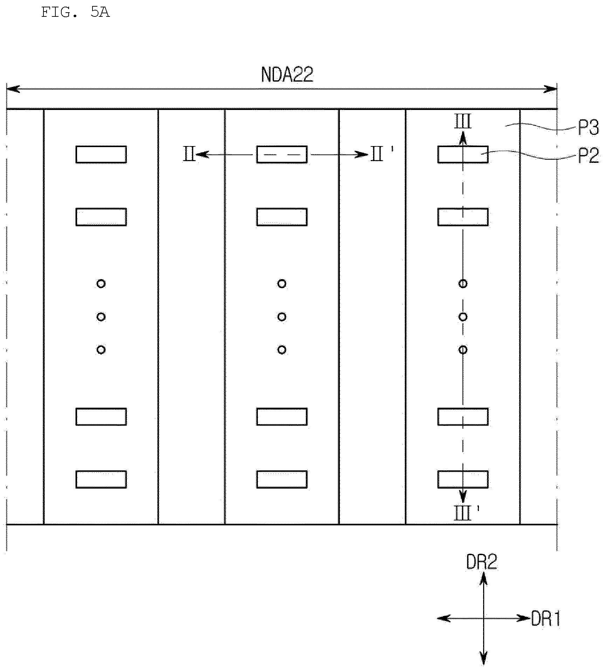

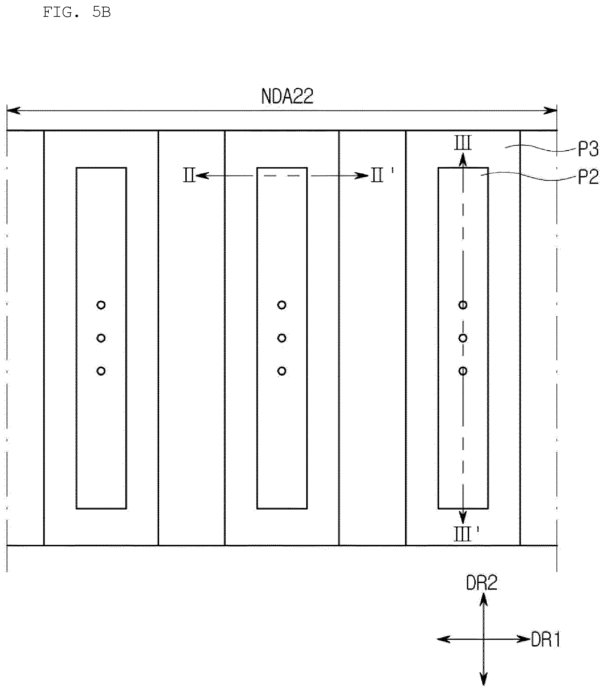

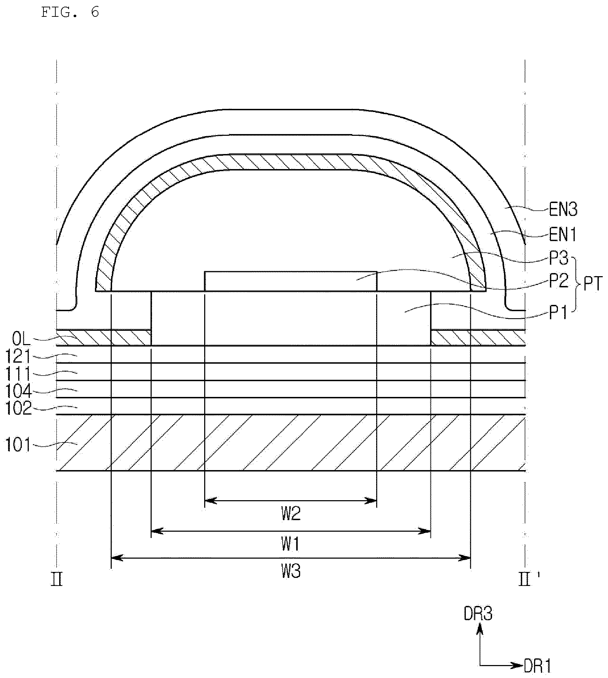

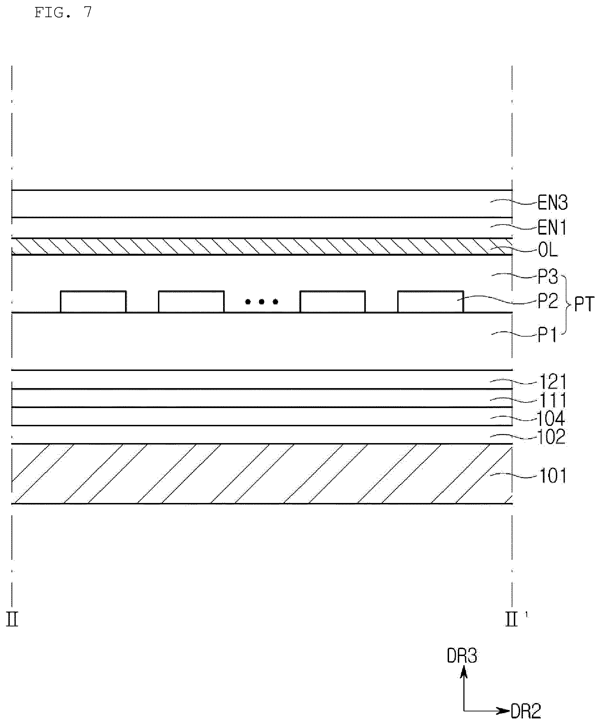

FIG. 5A is a plan view of a second-2 non-display area according to an exemplary embodiment of the present disclosure. FIG. 5B is a plan view of a second-2 non-display area according to an alternative embodiment. FIG. 6 is a cross-sectional view taken along the line II-II' in FIG. 5A. FIG. 7 is a cross-sectional view taken along the line III-III' in FIG. 5A. FIG. 5A shows the configuration (P2 and P3) of the organic material shorting portion in the second-2 non-display area (NDA22).

With reference to FIGS. 5A, 5B, 6, and 7, the organic pattern P3, in the planar view, extends along the second direction DR2, while being spaced apart from each other in the first direction DR1 to form the organic material shorting portions PT.

Each organic pattern P3 may correspond to a plurality of inorganic pattems P2. The plurality of inorganic patterns P2 corresponding to a single organic pattern P3 may be arranged to be spaced apart from each other along the second direction DR2. Although they form a single column extending along the second direction DR2 in FIG. 5A, the plurality of inorganic pattems P2 corresponding to a single organic pattern P3 are not limited thereto, and one or more columns of a plurality of inorganic pattems P2 may correspond to a single organic pattern P3, as well.

In some embodiments, a single organic pattern P3 may correspond to a single inorganic pattern P2 as shown in FIG. 5B. A single inorganic pattern P2 corresponding to a single organic pattern P3 may have a line shape extending along the second direction DR2. Hereinafter, the description is made of the organic material shorting portion PT with a focus on FIG. 5A. In the description with reference to FIGS. 6 and 7, detailed explanations of the parts already described in FIG. 4 will be omitted or briefly provided.

As shown in FIGS. 6 and 7, the undercut pattern P1 may have a width of W1, the inorganic pattern P2 may have a width of W2, and the organic pattern P3 may have a width of W3. As described above, the width W1 of the undercut pattern P1 may be greater than the width W2 of the inorganic pattern P2, and the width W3 of the organic pattern P3 may be greater than the width W1. As described above, the organic material shorting portion PT may serve to separate the organic layer OL. That is, the organic layer OL may be shorted by the organic material shorting portion PT. Therefore, as shown in FIG. 6, the organic layer OL may be distinguished by its placement on the upper surface of the second-1 interlayer insulating layer 121 and on the upper surface (top surface) of the organic pattern P3. The portions in contact with the upper surface of the second-1 interlayer insulating layer 121 and the upper surface (or surface) of the organic pattern P3 may be electrically isolated from each other.

The organic pattern P3, with a width W3 greater than the width W2 of the inorganic pattern P2, may cover the top and side surfaces of the inorganic pattern P2, contacting the top and side surfaces of the inorganic pattern P2. The inorganic pattern P2 may partially expose the top surface of the undercut patterns P1. That is, the inorganic pattern P2 covers the central portion of the top surface of the undercut pattern P1, while leaving the surrounding area exposed. The organic pattern P3 directly contacts the top surface of the outer periphery of the undercut pattern P1 exposed by the inorganic pattern P2.

Additionally, the organic material shorting portion PT may be completely covered by the first and second inorganic films EN1 and EN3. Specifically, the first inorganic film EN1 may cover the top surface of the organic layer OL, the side surface of the undercut pattern P1, the bottom surface of the organic pattern P3, and the surface of the organic layer OL under the organic pattern P3, while contacting the top surface of the organic layer OL, the side surface of the undercut pattern P1, the bottom surface of the organic pattern P3, and the surface of the organic layer OL under the organic pattern P3.

In an exemplary embodiment, the organic material shorting portion PT includes the inorganic pattern P2 that is positioned between the undercut pattern P1 and the organic pattern P3, and the organic pattern P3 contacts the top and side surfaces of the inorganic pattern P2 and the exposed upper surface of the undercut pattern P1, thereby increasing the contact area between the organic pattern P3 and the underlying inorganic pattern P2 and undercut pattern P1. As a result, the separation or detachment of the organic pattern P3 from the underlying undercut pattern P1 may be prevented in advance.

Furthermore, by preventing the separation or detachment of the organic pattern P3 from the underlying undercut pattern P1, it is possible to improve the structural reliability of the organic material shorting portion PT.

Moreover, by improving the structural reliability of the organic material shorting portion PT, the separation of the organic layer OL from the undercut pattern in the second-1 non-display area NDA21 and the second-2 non-display area NDA22 can be prevented, thereby protecting against moisture permeation into the display area DA through the organic layer OL

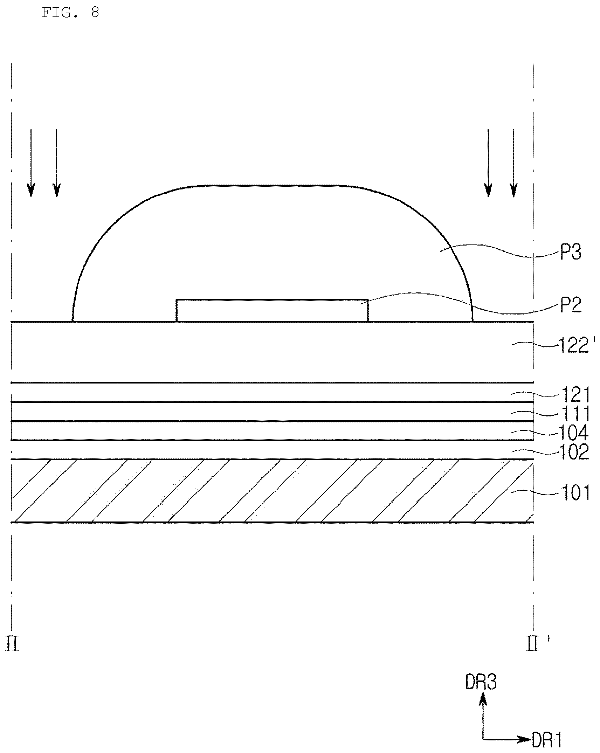

FIGS. 8 to 9 are cross-sectional views illustrating process steps of a method for fabricating an organic material shorting portion according to an exemplary embodiment.

As shown in FIG. 8, the second-2 interlayer insulating layer 122' is placed on the second-1 interlayer insulating layer 121. Sequentially, the inorganic pattern P2 is placed on the second-2 interlayer insulating layer 122'. Next, the organic pattern P3 is placed on the inorganic pattern P2. The inorganic pattern P2 is positioned on the passivation layer 131 of FIG. 4, and the organic pattern P3 may be positioned on the second planarization layer 141 of FIG. 4.

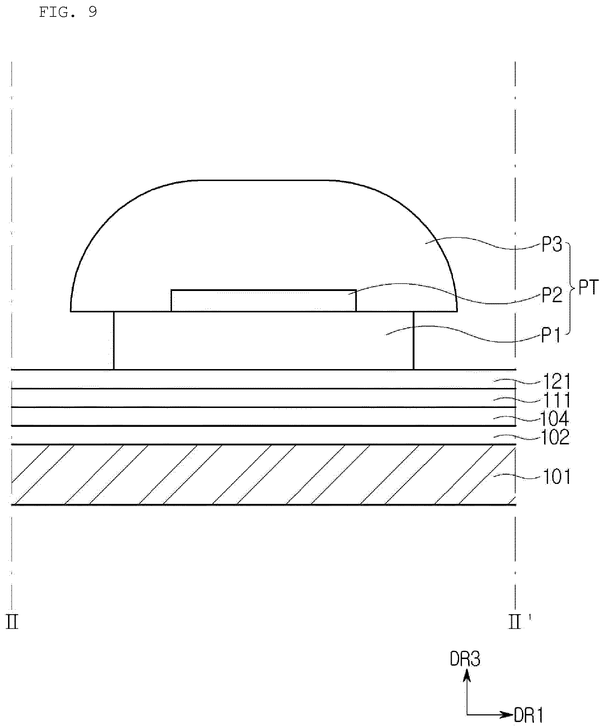

Subsequently, as shown in FIGS. 8 and 9, the undercut pattern P1 is formed by etching the second-2 interlayer insulating layer 122' through the organic pattern P3. The selectivity ratio of the etching solution for the organic pattern P3 in the etching process may be smaller than the selectivity ratio for the second-2 interlayer insulating layer 122'. Therefore, it is possible for the etching process to result in the etching of the second-2 interlayer insulating layer 122' beneath the organic pattern P3.

Hereinafter, descriptions are made of the organic material shorting portions according to other embodiments. FIG. 4 may also be referenced to describe the embodiments.

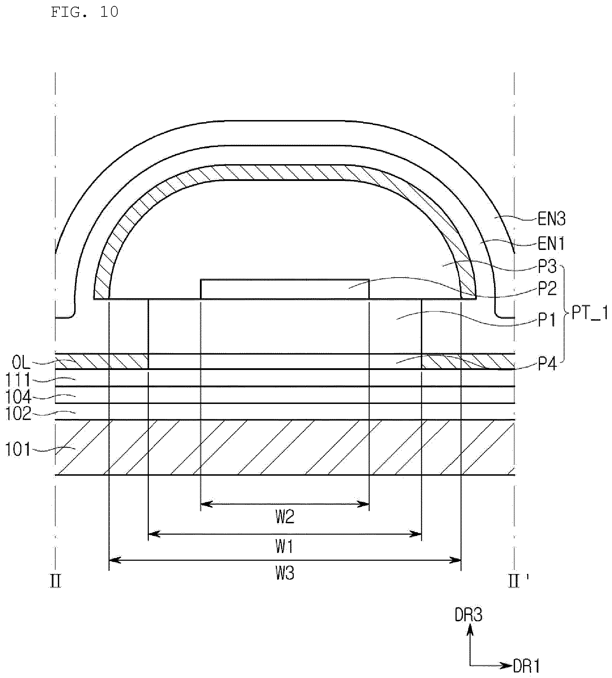

FIG. 10 is a cross-sectional view of an organic material shorting portion according to another embodiment of the present disclosure.

With reference to FIG. 10, the organic material shorting portion PT_1 according to this embodiment differs from the organic material shorting portion PT of FIG. 6 in that it includes an additional second undercut pattern P4.

The second undercut pattern P4 may be formed from the second-1 interlayer insulating layer (121 of FIG. 4). The width of the second undercut pattern P4 may be the same as the width W1 of the undercut pattern P1, but is not limited thereto. The organic layer OL may contact the top surface of the first interlayer insulating layer 111 and the side surface of the second undercut pattern P4.

In this embodiment, the organic material shorting portion PT_1 may be formed by etching not only the second-2 interlayer insulating layer 122' but also the second-1 interlayer insulating layer 121 during the etching process of the underlying inorganic layer through the organic pattems P3 of FIGS. 8 and 9.

The additional description that has already been made with reference to FIGS. 1 and 7 will be omitted.

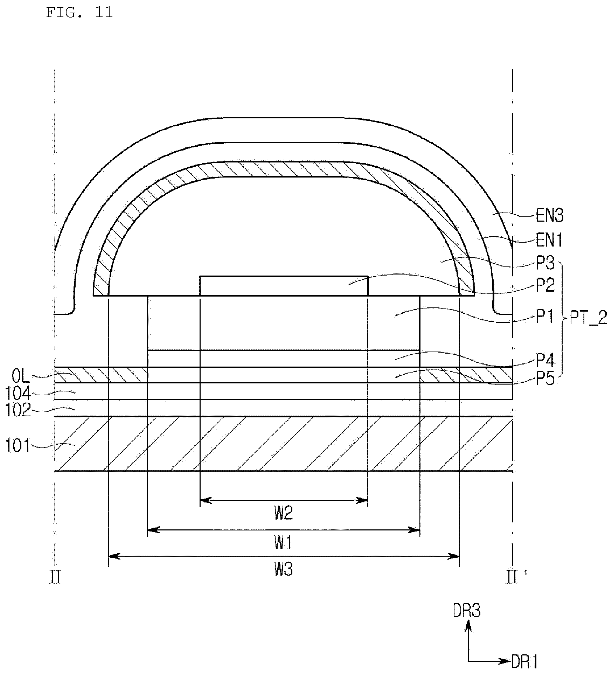

FIG. 11 is a cross-sectional view of an organic material shorting portion according to another embodiment of the present disclosure.

With reference to FIG. 11, the organic material shorting portion PT_2 according to this embodiment differs from the organic material shorting portion PT_1 of FIG. 10 in that it includes an additional third undercut pattern P5.

The third undercut pattern P5 may be formed from the first interlayer insulating layer 111. The width of the third undercut pattern P5 may be the same as the width W1 of the undercut pattern P1, but is not limited thereto. The organic layer OL may contact the top surface of the gate insulating layer 104 and the side surface of the third undercut pattern P5.

In this embodiment, the organic material shorting portion PT_2 may be formed by etching down to the first interlayer insulating layer 111 during the process of etching the underlying inorganic layer using the organic pattern P3 in FIGS. 8 and 9.

The additional description that has already been made with reference to FIGS. 1 and 11 will be omitted.

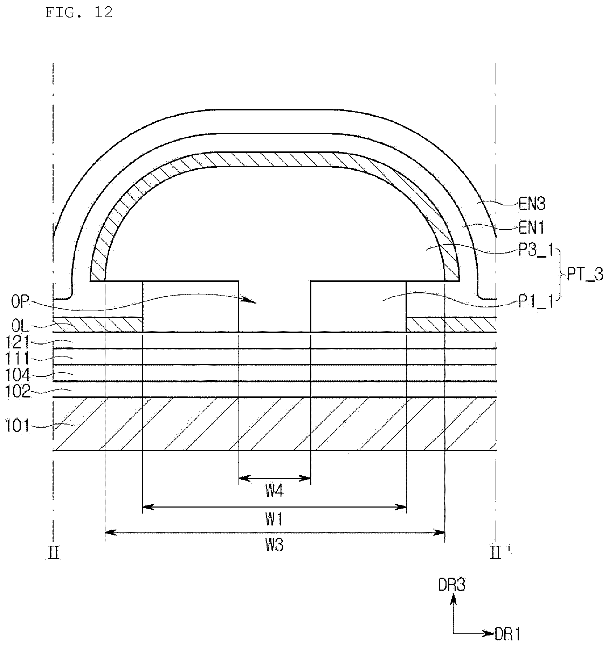

FIG. 12 is a cross-sectional view of an organic material shorting portion according to another embodiment of the present disclosure.

With reference to FIG. 12, the organic material shorting portion PT_3 according to this embodiment differs from the organic material shorting portion PT of FIG. 6 in that the undercut pattern P1_1 includes an opening OP.

In more detail, the opening OP may completely penetrate the undercut pattern P1_1 from the top surface to the bottom surface thereof in the thickness direction. The organic pattern P3_1 may fill the opening OP and directly contact the inner sidewall of the undercut pattern P1_1 within the opening. The organic pattern P3_1 may also directly contact the top surface of the second-1 interlayer insulating layer 121 within the opening OP. The width W4 of the opening OP may be smaller than the width W1 of the undercut pattern P1_1.

In this embodiment, the undercut pattern P1_1 includes the opening OP, and the organic pattern P3_1 fills the opening, allowing for increasing the contact area between the organic pattern P3_1 and the undercut pattern P1_1.

The additional description that has already been made with reference to FIGS. 1 and 7 will be omitted.

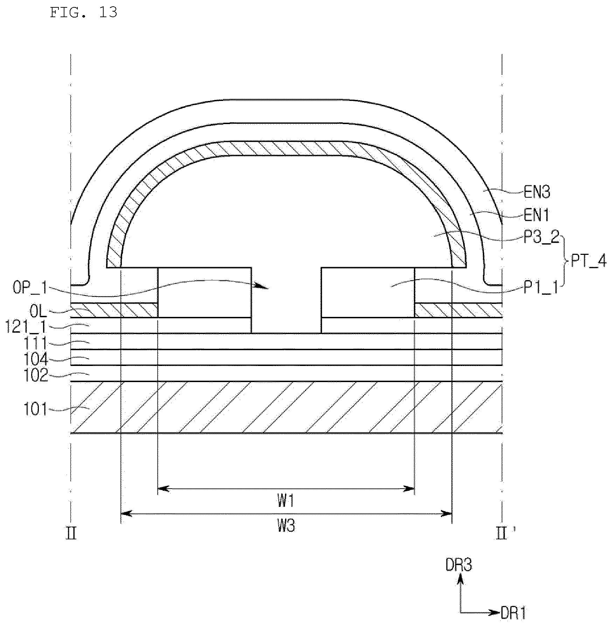

FIG. 13 is a cross-sectional view of an organic material shorting portion according to another embodiment of the present disclosure.

With reference to FIG. 13, the organic material shorting portion PT_4 differs from the organic material shorting portion PT_3 of FIG. 12 in that the opening OP_1 extends through the second-1 interlayer insulating layer 121_1.

The organic pattern P3_2 may directly contact the inner side of the second-1 interlayer insulating layer 121_1 within the opening OP_1. The organic pattern P3_2 may also directly contact the top surface of the first interlayer insulating layer 111 within the opening OP_1.

The additional description that has already been made with reference to FIG. 12 will be omitted.

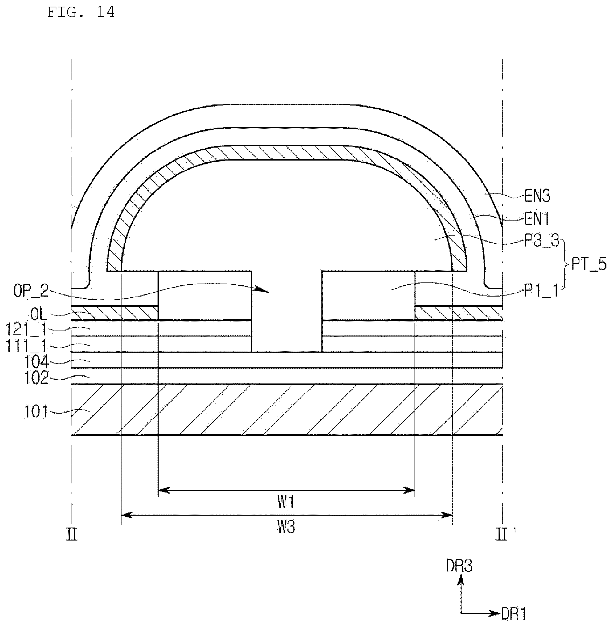

FIG. 14 is a cross-sectional view of an organic material shorting portion according to another embodiment of the present disclosure.

With reference to FIG. 14, the organic material shorting portion PT_5 according to this embodiment differs from the organic material shorting portion PT_4 of FIG. 13 in that the opening OP_2 extends through the first interlayer insulating layer 111_1.

The organic pattern P3_3 may directly contact the inner side of the first interlayer insulating layer 111_1 within the opening OP_2. The organic pattern P3_3 may also directly contact the top surface of the gate insulating layer 104 within the opening OP_2.

The additional description that has already been made with reference to FIG. 13 will be omitted.

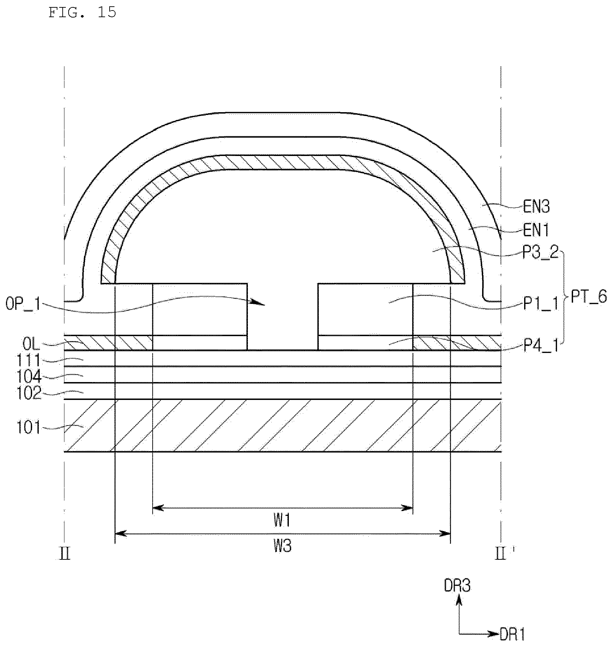

FIG. 15 is a cross-sectional view of an organic material shorting portion according to another embodiment of the present disclosure.

With reference to FIG. 15, the organic material shorting portion PT_6 according to this embodiment differs from the organic material shorting portion PT_1 of FIG. 10 in that the opening OP_1 extends through the second undercut pattern P4_1. The opening OP_1 may extend through both the undercut pattern P1_1 and the second undercut pattern P4_1. The organic pattern P3_2 may make direct contact with the inner side surfaces of both the undercut pattern P1_1 and the second undercut pattern P4_1 within the opening OP_1.

The additional description that has already been made with reference to FIGS. 10 and 13 will be omitted.

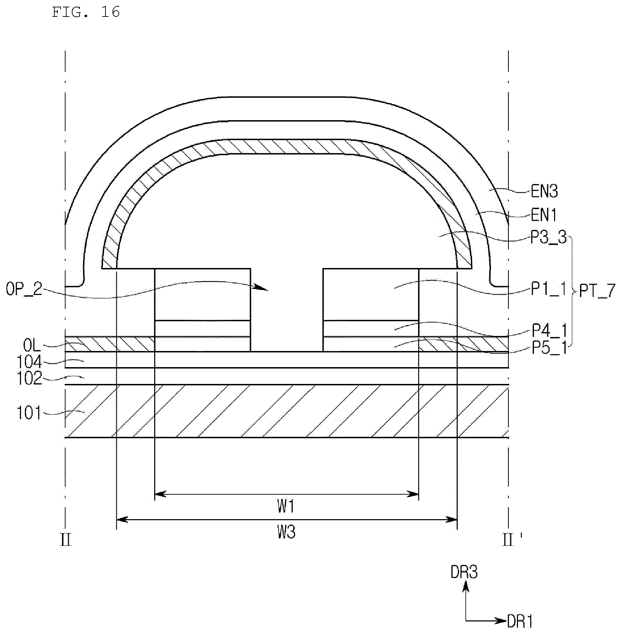

FIG. 16 is a cross-sectional view of an organic material shorting portion according to another embodiment of the present disclosure.

With reference to FIG. 16, the organic material shorting portion PT_7 according to this embodiment differs from the organic material shorting portion PT_2 of FIG. 11 in that the opening OP_2 extends through the third undercut pattern P5_1. The opening OP_2 may extend through the undercut pattern P1_1, the second undercut pattern P4_1, and the third undercut pattern P5_1. The organic pattern P3_3 may make direct contact with the inner side surfaces of the undercut pattern P1_1, the second undercut pattern P4_1, the third undercut pattern P5_1 within the opening OP_2.

The additional description that has already been made with reference to FIGS. 11 and 14 will be omitted.

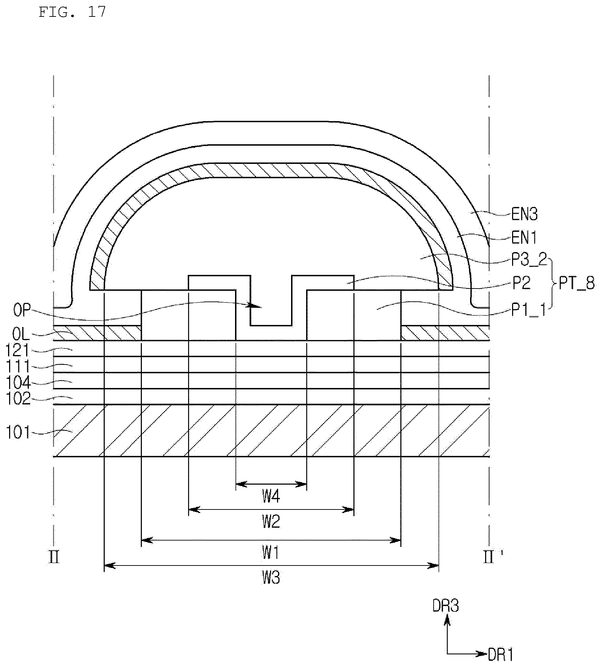

FIG. 17 is a cross-sectional view of an organic material shorting portion according to another embodiment of the present disclosure.

With reference to FIG. 17, the organic material shorting portion PT_8 according to this embodiment differs from the organic material shorting portion PT3_3 of FIG. 12 and the organic material shorting portion PT of FIG. 6 in that the inorganic pattern P2 may be positioned on top of the opening OP.

The inorganic pattern P2 may be placed not only on the top surface of the undercut pattern P1_1 where the opening OP is not formed but also within the opening OP. The inorganic pattern P2 may directly contact the inner side of the undercut pattern P1_1 within the opening OP. The width W2 of the inorganic pattern P2 may be larger than the width W4 of the opening OP.

The additional description that has already been made with reference to FIGS. 6 and 12 will be omitted.

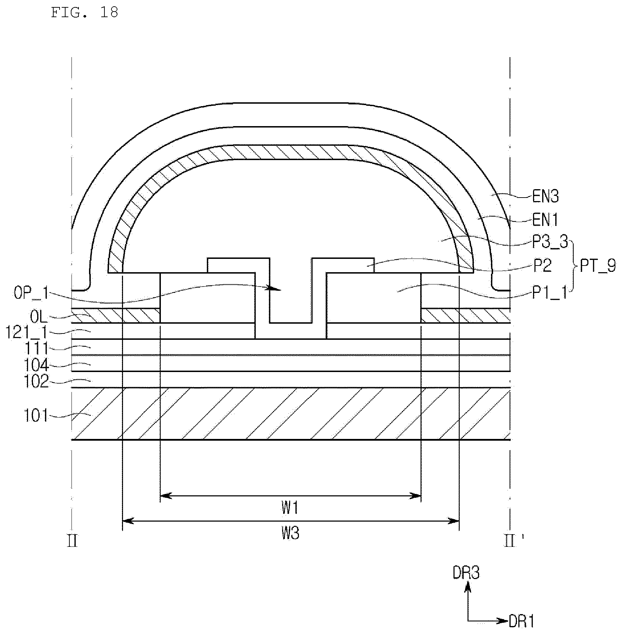

FIG. 18 is a cross-sectional view of an organic material shorting portion according to another embodiment of the present disclosure.

With reference to FIG. 18, the organic material shorting portion PT_9 according to this embodiment differs from the organic material shorting portion PT_4 of FIG. 13 and the organic material shorting portion PT of FIG. 6 in that the inorganic pattern P2 may be positioned within the opening OP_1.

The inorganic pattern P2 may be placed not only on the top surface of the undercut pattern P1_1 where the opening OP_1 is not formed but also within the opening OP_1. The inorganic pattern P2 may directly contact the inner side of the second-1 interlayer insulating layer 121_1 within the opening OP_1.

The additional description that has already been made with reference to FIGS. 6 and 13 will be omitted.

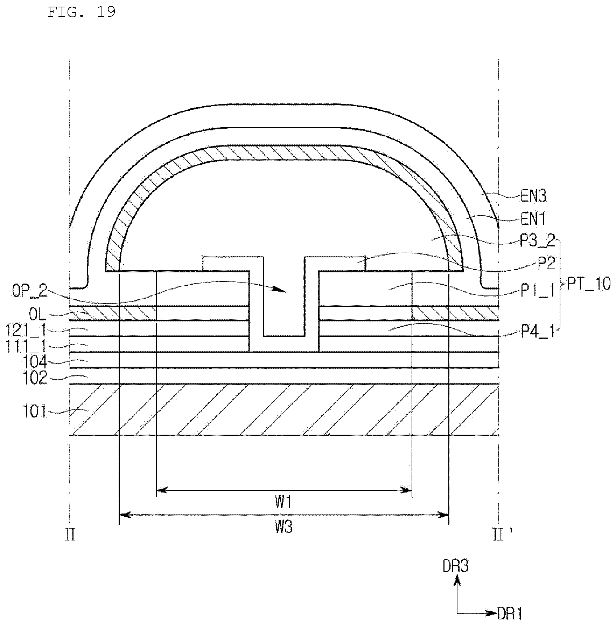

FIG. 19 is a cross-sectional view of an organic material shorting portion according to another embodiment of the present disclosure.

With reference to FIG. 19, the organic material shorting portion PT_10 according to this embodiment differs from the organic material shorting portion PT_5 of FIG. 14 and the organic material shorting portion PT of FIG. 6 in that the undercut pattern P1_1 includes an opening PT_5.

The inorganic pattern P2 may be placed not only on the top surface of the undercut pattern P1_1 where the opening OP_2 is not formed but also within the opening OP_2. The inorganic pattern P2 may directly contact the inner side of the first interlayer insulating layer 111_1 within the opening OP_2.

The additional description that has already been made with reference to FIGS. 6 and 14 will be omitted.

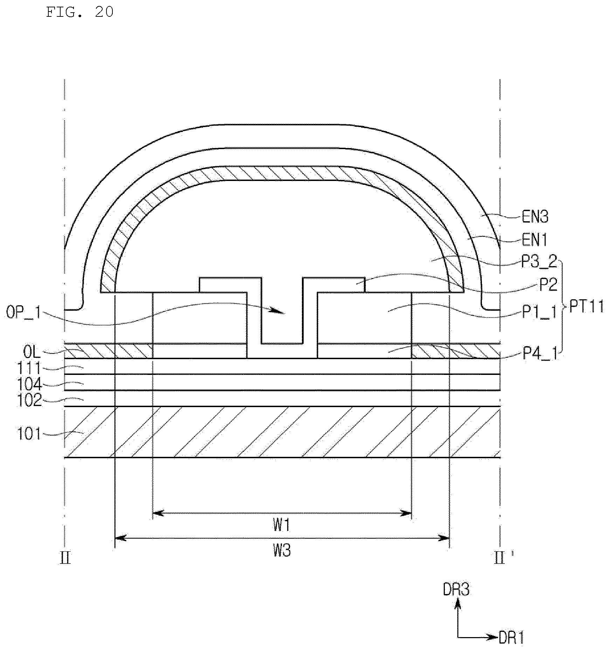

FIG. 20 is a cross-sectional view of an organic material shorting portion according to another embodiment of the present disclosure.

With reference to FIG. 20, the organic material shorting portion PT_11 according to this embodiment differs from the organic material shorting portion PT_6 of FIG. 15 and the organic material shorting portion PT of FIG. 6 in that the inorganic pattern P2 may be positioned within the opening OP_1.

The inorganic pattern P2 may be placed not only on the top surface of the undercut pattern P1_1 where the opening OP_1 is not formed but also within the opening OP_1. The inorganic pattern P2 may also directly contact the inner surface of the second undercut pattern P4_1 within the opening OP_1.

The additional description that has already been made with reference to FIGS. 6 and 15 will be omitted.

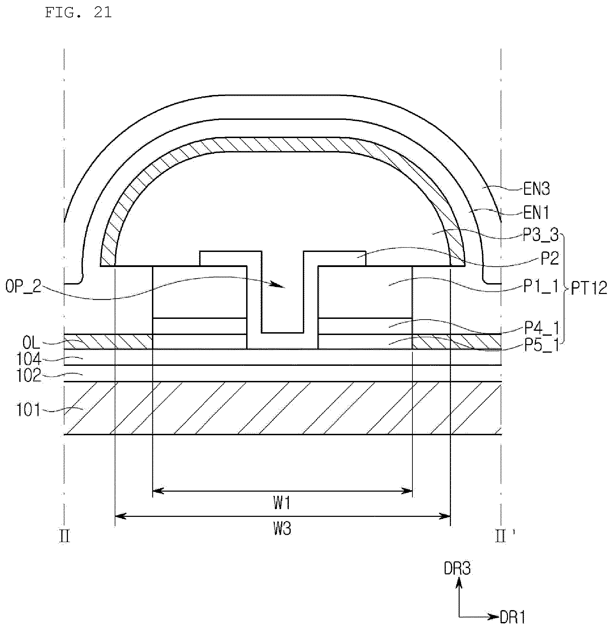

FIG. 21 is a cross-sectional view of an organic material shorting portion according to another embodiment of the present disclosure.

With reference to FIG. 21, the organic material shorting portion PT_12 according to this embodiment differs from the organic material shorting portion PT_7 of FIG. 16 and the organic material shorting portion PT of FIG. 6 in that the inorganic pattern P2 may be positioned within the opening OP_2.

The inorganic pattern P2 may be placed not only on the top surface of the undercut pattern P1_1 where the opening OP_2 is not formed but also within the opening OP_2. The inorganic pattern P2 may also directly contact the inner surface of the third undercut pattern P5_1 within the opening OP_2.

The additional description that has already been made with reference to FIGS. 6 and 16 will be omitted.

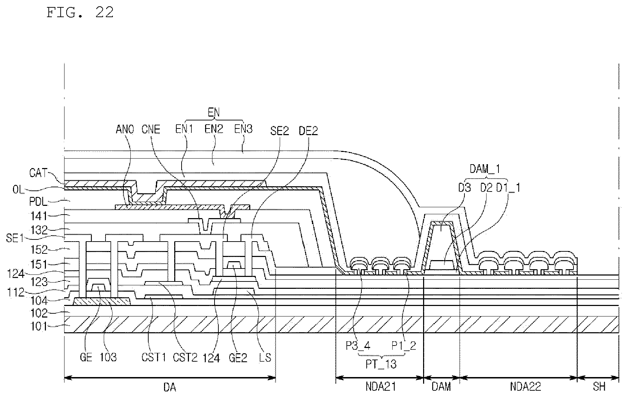

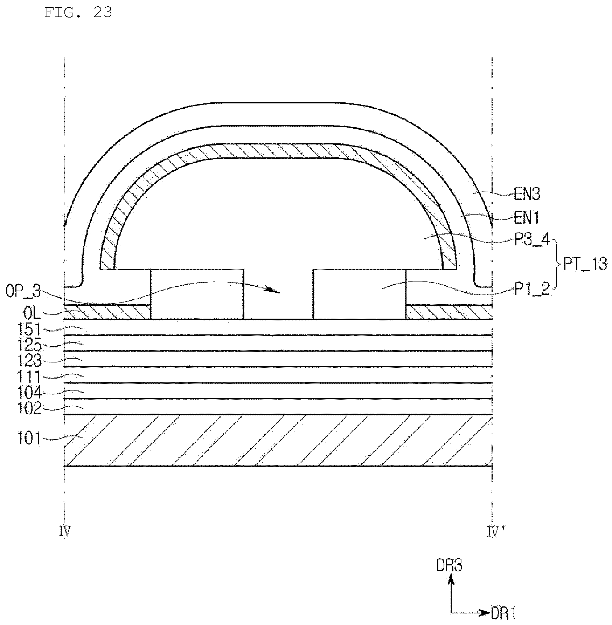

FIG. 22 is a cross-sectional view of a display area, second non-display area, dam area, and sensor hole according to another embodiment of the present disclosure. FIG. 23 is a cross-sectional view of the organic material shorting portion in FIG. 22.

With reference to FIGS. 22 and 23, the display device according to this embodiment differs from the display device of FIG. 4 in that the display device includes the second conductive layer 120 that further includes a light-shielding pattern LS overlapping with the second semiconductor layer 124 to be described later, the second buffer layer 123 on the second conductive layer 120, the second semiconductor layer 124 on top of the second buffer layer 123, the second gate insulating layer 125 on the second semiconductor layer 124, and a fifth conductive layer 150 including the second gate electrode GE2 on the second gate insulating layer 125, the third-1 interlayer insulating layer 151 on the fifth conductive layer 150, and the third-2 interlayer insulating layer 152 between the third-1 interlayer insulating layer and the third conductive layer 130, and the second interlayer insulating layer 121 and 122 and the passivation layer 131 are omitted.

The light-shielding pattern LS may overlap with the second semiconductor layer 124.

The second buffer layer 123 may include one of the materials exemplified for the buffer layer 102 in FIG. 4. For example, the second buffer layer 123 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The second semiconductor layer 124 may include oxide semiconductors. The oxide semiconductors may include binary compound systems (ABx), ternary compound systems (ABxCy), or quaternary compound systems (ABxCyDz) containing, for example, indium, zinc, gallium, tin, titanium, aluminum, hafnium (Hf), zirconium (Zr), magnesium (Mg), and other elements. In an exemplary embodiment, the second semiconductor layer 124 may include indium tin zinc oxide (ITZO), which is an oxide compound containing indium, tin, and zinc, or indium gallium zinc oxide (IGZO), which is an oxide compound containing indium, gallium, and zinc.

The second gate insulating layer 125 may include at least one of the materials exemplified for the gate insulating layer 104 in FIG. 4. The second gate insulating layer 125 may include silicon compounds, metal oxides, and the like. For example, the second gate insulating layer 125 may include silicon oxide, silicon nitride, silicon oxynitride, aluminum oxide, tantalum oxide, hafnium oxide, zirconium oxide, titanium oxide, and the like, but not limited thereto. These materials may be used individually or in combination with each other. The second gate insulating layer 125 may be a single layer, but not limited thereto. The second gate insulating layer 125 may also be a multilayer film composed of stacked layers of different materials.

The fifth conductive layer 150 may include at least one of the materials exemplified for the first conductive layer 110 in FIG. 4. For example, the fifth conductive layer 150 may include one or more selected metals from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). The second gate electrode GE2 may overlap with the channel region of the second semiconductor layer 124.

The third-1 interlayer insulating layer 151 and the third-2 interlayer insulating layer 152 may each include at least one of the materials exemplified for the second-1 interlayer insulating layer 121 and the second-2 interlayer insulating layer 122 in FIG. 4, respectively. For example, the third-1 interlayer insulating layer 151 may include silicon oxide, and the third-2 interlayer insulating layer 152 may include silicon nitride, and the present disclosure is not limited thereto. For example, the third-1 interlayer insulating layer 151 may include any one of inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like, and the third-2 interlayer insulating layer 152 may include any one of inorganic insulating materials such as silicon oxide, silicon nitride, silicon oxynitride, hafnium oxide, aluminum oxide, titanium oxide, tantalum oxide, zinc oxide and the like, as well as organic insulating materials such as polyacrylates resin, epoxy resin, phenolic resin, polyamides resin, polyimides resin, unsaturated polyesters resin, polyphenylenethers resin, polyphenylenesulfides resin, benzocyclobutene (BCB) and the like, and the third-1 interlayer insulating layer 151 and the third-2 interlayer insulating layer 152 may be made of different materials.

The third conductive layer 130 may include the first source electrode SE1, the first drain electrode DE1, the second source electrode SE2, and the second drain electrode DE2. The first source electrode SE1 may be connected to the source region of the first semiconductor layer 103, the first drain electrode DE1 may be connected to the drain region of the first semiconductor layer 103, the second source electrode SE2 may be connected to the source region of the second semiconductor layer 124, and the second drain electrode DE2 may be connected to the drain region of the second semiconductor layer 124.

The second source electrode SE2 may also be connected to the second electrode CST2. The second source electrode SE2 may be connected to an upper connecting electrode CNE.

The third-2 interlayer insulating layer 152 may form an undercut pattern P1_2 of an organic material shorting portion PT_13 in the second-1 non-display area NDA21 and the second-2 non-display area NDA22, respectively. The organic material shorting portion PT_13 may be provided in multiple quantities. The plurality of organic material shorting portions PT_13 may be placed in the second-1 non-display area NDA21 and the second-2 non-display area NDA22, and adjacent organic material shorting portions PT_13 may be arranged to be spaced apart from each other. The third-2 interlayer insulating layer 152 may form a first dam portion D1_1 of a dam DAM_1 in the dam area.

As described with reference to FIG. 23, the undercut pattern P1_2 may include an opening OP_3. The opening OP_3 may completely penetrate through the upper surface of the undercut pattern P1 2. The organic pattern P3_4 may fill the opening OP_3.

The organic material shorting portion PT_13 may serve to short the organic layer OL. That is, the organic layer OL may be shorted by the organic material shorting part PT_13. Therefore, as shown in FIG. 23, the organic layer OL may be divided into a portion in contact with the upper surface of the third-1 interlayer insulating layer 151 and a portion located on the upper surface (or surface) of the organic pattern P3_4. The portion in contact with the upper surface of the third-1 interlayer insulating layer 151 and the portion located on the upper surface (or surface) of the organic pattern P3_4 may be shorted to each other.

The additional description that has already been made with reference to FIGS. 1 to 7 and 12 will be omitted.

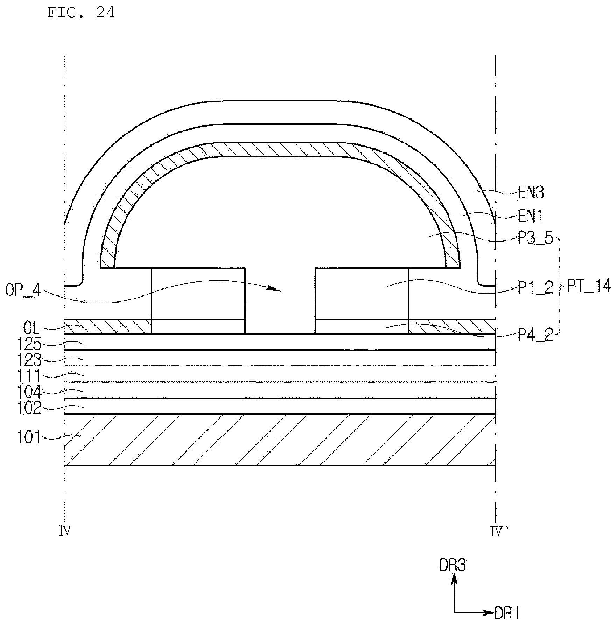

FIG. 24 is a cross-sectional view of an organic material shorting portion according to another embodiment of the present disclosure.

With reference to FIG. 24, the organic material shorting portion PT_14 according to this embodiment differs from the organic material shorting portion PT_13 of FIG. 23 in that it further includes a second undercut pattern P4_2 and the opening OP_4 extends through the second undercut pattern P4_2.

The second undercut pattern P4_2 may be positioned on the same layer as the third-1 interlayer insulating layer 151. The organic layer OL may be directly positioned on the upper surface of the second gate insulating layer 125.

The additional description that has already been made with reference to FIGS. 10 and 23 will be omitted.

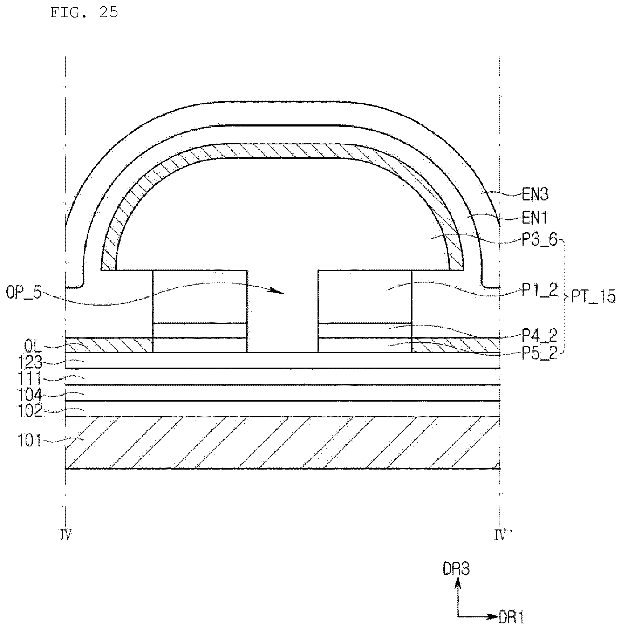

FIG. 25 is a cross-sectional view of an organic material shorting portion according to another embodiment of the present disclosure.

With reference to FIG. 25, the organic material shorting portion PT_15 according to this embodiment differs from the organic material shorting portion PT_14 of FIG. 24 in that it further includes the third undercut pattern P5_2 and the opening OP_5 extends through the third undercut pattern P5_2.

The third undercut pattern P5_2 may be positioned in the same layer as the second gate insulating layer 125. The organic layer OL may be directly positioned on the upper surface of the second buffer layer 123.

The additional description that has already been made with reference to FIGS. 11 and 24 will be omitted.

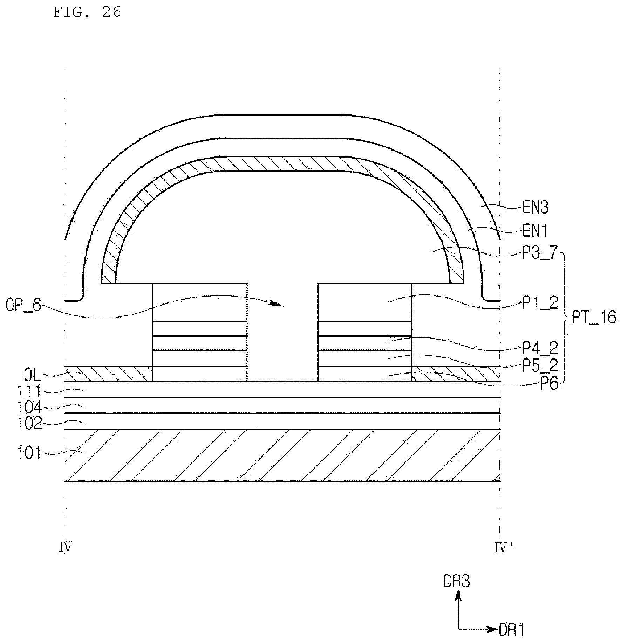

FIG. 26 is a cross-sectional view of an organic material shorting portion according to another embodiment of the present disclosure.

With reference to FIG. 26, the organic material shorting portion PT_16 according to this embodiment differs from the organic material shorting portion PT_1 5 in that includes the fourth undercut pattern P6 positioned between the first interlayer insulating layer 111 and the third undercut pattern P5_2 and the opening OP_6 extends through the fourth undercut pattern P6.

The fourth undercut pattern P6 may be positioned in the same layer as the second buffer layer 123. The organic layer OL may be directly positioned on the upper surface of the first interlayer insulating layer 111.

The additional description that has already been made with reference to FIG. 25 will be omitted.

A display device according to an aspect of the present disclosure comprises: a substrate comprising a display area, a non-display area adjacent to the display area, and a sensor hole at least partly surrounded by the non-display area; and an organic material shorting portion positioned in the non-display area, wherein the organic material shorting portion comprises: an undercut pattern, an organic pattern positioned on the undercut pattern and being larger in width than the undercut pattern, and an inorganic pattern positioned between the undercut pattern and the organic pattern and being smaller in width than the undercut pattern.

An upper surface and side surfaces of the inorganic pattern contacts the organic pattern.

The inorganic pattern exposes an upper surface of the undercut pattern partially, and the organic pattern contacts the upper surface of the exposed undercut pattern directly.

The inorganic pattern contacts a central portion of the upper surface of the undercut pattern and exposes a remaining portion of the upper surface of the undercut pattern.

The display device may further comprise an organic light-emitting device positioned in the display area of the substrate.

The organic light-emitting device may comprise an anode electrode on the substrate, an organic layer on the anode electrode, and a cathode electrode on the organic layer.

The organic layer may include: first organic layers contacting side surfaces of the undercut pattern, and a second organic layer contacting an upper surface and side surfaces of the organic pattern.

The first organic layers and the second organic layer may be shorted by the organic material shorting portion.

The organic layer may be positioned in the non-display area and may be shorted by the organic material shorting portion.

The organic layer may be positioned on upper and side surfaces of the organic pattern.

The display device may further comprise an encapsulation layer on the organic light-emitting device, wherein the encapsulation layer comprises a first inorganic film, an organic film on the first inorganic film, and a second inorganic film.

The non-display area may comprise an area having the organic material shorting portion provided therein, and a dam area adjacent to the area.

The organic material shorting portion may be provided in multiple quantities, and the multiple organic material shorting portions may comprise a first organic material shorting portion positioned between the display area and the dam area, and a second organic shorting material portion positioned between the dam area and the sensor hole.

The organic layer may be positioned outside the dam area in a planar view, and the first inorganic film and the second inorganic film may contact each other in the dam area and the second organic material shorting portion.

The first inorganic film may directly contact the upper and side surfaces of the organic pattern.

The first inorganic film may directly contact a side surface of the undercut pattern and a lower surface of the organic pattern.

The inorganic pattern may directly contact an upper surface of the undercut pattern.

The undercut pattern may comprise a plurality of layers.

A display device according to another aspect of the present disclosure comprises: a substrate comprising a display area, a non-display area adjacent to the display area, and a sensor hole at least partly surrounded by the non-display area; and an organic material shorting portion positioned in the non-display area, wherein the organic material shorting portion comprises an undercut pattern, and an organic pattern positioned on the undercut pattern and being larger in width than the undercut pattern, and wherein the undercut pattern comprises an opening penetrating the undercut pattern from an upper surface thereof, and the organic pattern fills the opening.

The organic pattern may directly contact the undercut pattern within the opening.

The display device may further comprise an organic light-emitting device positioned in the display area.

The organic light-emitting device may comprise an anode electrode on the substrate, an organic layer on the anode electrode, and a cathode electrode on the organic layer.

The organic layer may include first organic layers contacting side surfaces of the undercut pattern, and a second organic layer contacting an upper surface and side surfaces of the organic pattern.

The first organic layers and the second organic layer may be shorted by the organic material shorting portion.

The display device may further comprise at least one inorganic layer positioned between the undercut pattern and the substrate, wherein the opening penetrates the at least one inorganic layer, and the organic pattern contacts the at least one inorganic layer within the opening.

The undercut pattern may comprise a plurality of layers.

The organic material shorting portion may further comprise an inorganic pattern positioned between the undercut pattern and the organic pattern.

The inorganic pattern may be smaller in width than the undercut pattern.

The inorganic pattern may be larger in width than the opening.

The inorganic pattern may be positioned on an upper surface of the undercut pattern outside the opening and within the opening.

The inorganic pattern may contact a side surface of the undercut pattern within the opening.

Although embodiments of this invention have been described above with reference to the accompanying drawings, it will be understood by those skilled in the art that this invention can be implemented without departing the technical concept of this invention. Therefore, it should be understood that the embodiments described above are exemplary and not limited in all respects.

### DESCRIPTION OF REFERENCE NUMERALS

PT: organic material shorting portion
P1: undercut pattern
P2: inorganic pattern
P3: organic pattern
OP: opening

## Claims

1. A display device comprising:
a substrate (101) comprising a display area (DA), a non-display area (NDA1, NDA2) adjacent to the display area (DA), and a sensor hole (SH) at least partly surrounded by the non-display area (NDA1, NDA2); and
an organic material shorting portion (PT) positioned in the non-display area (NDA1, NDA2),
wherein the organic material shorting portion (PT) comprises:
an undercut pattern (P1),
an organic pattern (P3) positioned on the undercut pattern (P1) and being larger in width than the undercut pattern (P1), and
an inorganic pattern (P2) positioned between the undercut pattern (P1) and the organic pattern (P3) and being smaller in width than the undercut pattern (P1);
wherein an upper surface and side surfaces of the inorganic pattern (P2) contact the organic pattern (P3);
wherein the inorganic pattern (P2) exposes an upper surface of the undercut pattern (P1) partially, and the organic pattern (P3) contacts the upper surface of the exposed undercut pattern (P1) directly; and
wherein the inorganic pattern (P2) contacts a central portion of the upper surface of the undercut pattern (P1) and exposes a remaining portion of the upper surface of the undercut pattern (P1).

2. The display device of claim 1, further comprising an organic light-emitting device positioned in the display area (DA) of the substrate (101).

3. The display device of claim 2, wherein the organic light-emitting device comprises an anode electrode (ANO) on the substrate (101), an organic layer (OL) on the anode electrode (ANO), and a cathode electrode (CAT) on the organic layer (OL).

4. The display device of claim 3, wherein the organic layer (OL) includes:
first organic layers contacting side surfaces of the undercut pattern (P1), and
a second organic layer contacting an upper surface and side surfaces of the organic pattern (P3),
wherein, preferably, the first organic layers and the second organic layer are shorted by the organic material shorting portion (PT).

5. The display device of claim 3, wherein the organic layer (OL) is positioned in the non-display area (NDA1, NDA2) and is shorted by the organic material shorting portion (PT).

6. The display device of claim 5, wherein the organic layer (OL) is positioned on upper and side surfaces of the organic pattern (P3).

7. The display device of claim 6, further comprising an encapsulation layer (EN) on the organic light-emitting device,
wherein the encapsulation layer (EN) comprises a first inorganic film (EN1), an organic film (EN2) on the first inorganic film (EN1), and a second inorganic film (EN3).

8. The display device of claim 7, wherein the non-display area (NDA1, NDA2) comprises an area having the organic material shorting portion (PT) provided therein, and a dam area adjacent to the area.

9. The display device of claim 8, wherein the organic material shorting portion (PT) is provided in multiple quantities, and
the multiple organic material shorting portions (PT) comprise a first organic material shorting portion (PT) positioned between the display area (DA) and the dam area, and a second organic shorting material portion (PT) positioned between the dam area and the sensor hole (SH).

10. The display device of claim 9, wherein the organic layer (OL) is positioned outside the dam area in a planar view, and
the first inorganic film (EN1) and the second inorganic film (EN3) contact each other in the dam area and the second organic material shorting portion (PT).

11. The display device of claim 10, wherein the first inorganic film (EN1) directly contacts the upper and side surfaces of the organic pattern (P3),
wherein, preferably, the first inorganic film (EN1) directly contacts a side surface of the undercut pattern (P1) and a lower surface of the organic pattern (P3).

12. The display device of any of claims 1 to 11, wherein the inorganic pattern (P2) directly contacts an upper surface of the undercut pattern (P1), and/or
wherein the undercut pattern (P1) comprises a plurality of layers.

## Patentansprüche

1. Anzeigevorrichtung, aufweisend:
ein Substrat (101) aufweisend einen Anzeigebereich (DA), einen zu dem Anzeigebereich (DA) benachbarten Nicht-Anzeigebereich (NDA1, NDA2) und eine Sensoröffnung (SH), die zumindest teilweise von dem Nicht-Anzeigebereich (NDA1, NDA2) umgeben ist, und
einen Organisches-Material-Kurzschlussabschnitt (PT), der im Nicht-Anzeigebereich (NDA1, NDA2) angeordnet ist,
wobei der Organisches-Material-Kurzschlussabschnitt (PT) aufweist:
eine Hinterschneidungsstruktur (P1),
eine organische Struktur (P3), die auf der Hinterschneidungsstruktur (P1) angeordnet ist und eine größere Breite als die Hinterschneidungsstruktur (P1) hat, und
eine anorganische Struktur (P2), die zwischen der Hinterschneidungsstruktur (P1) und der organischen Struktur (P3) angeordnet ist und eine geringere Breite als die Hinterschneidungsstruktur (P1) hat,
wobei eine obere Fläche und Seitenflächen der anorganischen Struktur (P2) die organische Struktur (P3) kontaktieren,
wobei die anorganische Struktur (P2) eine obere Fläche der Hinterschneidungsstruktur (P1) teilweise freilegt und die organische Struktur (P3) die obere Fläche der freigelegten Hinterschneidungsstruktur (P1) direkt kontaktiert, und
wobei die anorganische Struktur (P2) einen zentralen Abschnitt der oberen Fläche der Hinterschneidungsstruktur (P1) kontaktiert und einen verbleibenden Abschnitt der oberen Fläche der Hinterschneidungsstruktur (P1) freilegt.

2. Anzeigevorrichtung gemäß Anspruch 1, ferner aufweisend eine organische lichtemittierende Vorrichtung, die im Anzeigebereich (DA) des Substrats (101) angeordnet ist.

3. Anzeigevorrichtung gemäß Anspruch 2, wobei die organische lichtemittierende Vorrichtung eine Anodenelektrode (ANO) auf dem Substrat (101), eine organische Schicht (OL) auf der Anodenelektrode (ANO) und eine Kathodenelektrode (CAT) auf der organischen Schicht (OL) aufweist.

4. Anzeigevorrichtung gemäß Anspruch 3, wobei die organische Schicht (OL) aufweist:
erste organische Schichten, die Seitenflächen der Hinterschneidungsstruktur (P1) kontaktieren, und
eine zweite organische Schicht, die eine obere Fläche und Seitenflächen der organischen Struktur (P3) kontaktiert,
wobei vorzugsweise die ersten organischen Schichten und die zweite organische Schicht durch den Organisches-Material-Kurzschlussabschnitt (PT) kurzgeschlossen sind.

5. Anzeigevorrichtung gemäß Anspruch 3, wobei die organische Schicht (OL) im Nicht-Anzeigebereich (NDA1, NDA2) angeordnet ist und durch den Organisches-Material-Kurzschlussabschnitt (PT) kurzgeschlossen ist.

6. Anzeigevorrichtung gemäß Anspruch 5, wobei die organische Schicht (OL) auf einer oberen und Seitenflächen der organischen Struktur (P3) angeordnet ist.

7. Anzeigevorrichtung gemäß Anspruch 6, ferner aufweisend eine Verkapselungsschicht (EN) auf der organischen lichtemittierenden Vorrichtung,
wobei die Verkapselungsschicht (EN) einen ersten anorganischen Film (EN1), einen organischen Film (EN2) auf dem ersten anorganischen Film (EN1) und einen zweiten anorganischen Film (EN3) aufweist.

8. Anzeigevorrichtung gemäß Anspruch 7, wobei der Nicht-Anzeigebereich (NDA1, NDA2) einen Bereich, in dem der Organisches-Material-Kurzschlussabschnitt (PT) bereitgestellt ist, sowie einen zu dem Bereich benachbarten Dammbereich aufweist.

9. Anzeigevorrichtung gemäß Anspruch 8, wobei der Organisches-Material-Kurzschlussabschnitt (PT) in mehrfacher Anzahl bereitgestellt ist und
die mehreren Organisches-Material-Kurzschlussabschnitte (PT) aufweisen: einen ersten Organisches-Material-Kurzschlussabschnitt (PT), der zwischen dem Anzeigebereich (DA) und dem Dammbereich angeordnet ist, und einen zweiten Organisches-Material-Kurzschlussabschnitt (PT), der zwischen dem Dammbereich und der Sensoröffnung (SH) angeordnet ist.

10. Anzeigevorrichtung gemäß Anspruch 9, wobei die organische Schicht (OL) in einer Draufsicht außerhalb des Dammbereichs angeordnet ist, und
der erste anorganische Film (EN1) und der zweite anorganische Film (EN3) einander im Dammbereich und dem zweiten Organisches-Material-Kurzschlussabschnitt (PT) kontaktieren.

11. Anzeigevorrichtung gemäß Anspruch 10, wobei der erste anorganische Film (EN1) die obere und Seitenflächen der organischen Struktur (P3) direkt kontaktiert,
wobei vorzugsweise der erste anorganische Film (EN1) eine Seitenfläche der Hinterschneidungsstruktur (P1) und eine untere Fläche der organischen Struktur (P3) direkt kontaktiert.

12. Anzeigevorrichtung gemäß irgendeinem der Ansprüche 1 bis 11, wobei die anorganische Struktur (P2) eine obere Fläche der Hinterschneidungsstruktur (P1) direkt kontaktiert, und/oder
wobei die Hinterschneidungsstruktur (P1) eine Mehrzahl von Schichten aufweist.

## Revendications

1. Dispositif d'affichage comprenant :
un substrat (101) comprenant une zone d'affichage (DA), une zone de non affichage (NDA1, NDA2) adjacente à la zone d'affichage (DA), et un trou de capteur (SH) au moins partiellement entouré par la zone de non affichage (NDA1, NDA2) ; et
une partie de court-circuit en matériau organique (PT) positionnée dans la zone de non affichage (NDA1, NDA2),
dans lequel la partie de court-circuit en matériau organique (PT) comprend :
un motif en contre-dépouille (P1),
un motif organique (P3) positionné sur le motif en contre-dépouille (P1) et dont la largeur est supérieure à celle du motif en contre-dépouille (P1), et
un motif inorganique (P2) positionné entre le motif en contre-dépouille (P1) et le motif organique (P3) et dont la largeur est inférieure à celle du motif en contre-dépouille (P1) ;
dans lequel une surface supérieure et des surfaces latérales du motif inorganique (P2) sont en contact avec le motif organique (P3) ;
dans lequel le motif inorganique (P2) expose partiellement une surface supérieure du motif en contre-dépouille (P1), et le motif organique (P3) est en contact direct avec la surface supérieure du motif en contre-dépouille (P1) exposé ; et
dans lequel le motif inorganique (P2) est en contact avec une partie centrale de la surface supérieure du motif en contre-dépouille (P1) et expose une partie restante de la surface supérieure du motif en contre-dépouille (P1).

2. Dispositif d'affichage selon la revendication 1, comprenant en outre un dispositif électroluminescent organique positionné dans la zone d'affichage (DA) du substrat (101).

3. Dispositif d'affichage selon la revendication 2, dans lequel le dispositif électroluminescent organique comprend une électrode d'anode (ANO) sur le substrat (101), une couche organique (OL) sur l'électrode d'anode (ANO), et une électrode de cathode (CAT) sur la couche organique (OL).

4. Dispositif d'affichage selon la revendication 3, dans lequel la couche organique (OL) comprend :
des premières couches organiques en contact avec des surfaces latérales du motif en contre-dépouille (P1), et
une deuxième couche organique en contact avec une surface supérieure et des surfaces latérales du motif organique (P3),
dans lequel, de préférence, les premières couches organiques et la deuxième couche organique sont court-circuitées par la partie de court-circuit en matériau organique (PT).

5. Dispositif d'affichage selon la revendication 3, dans lequel la couche organique (OL) est positionnée dans la zone de non affichage (NDA1, NDA2) et est court-circuitée par la partie de court-circuit en matériau organique (PT).

6. Dispositif d'affichage selon la revendication 5, dans lequel la couche organique (OL) est positionnée sur des surfaces supérieure et latérales du motif organique (P3).

7. Dispositif d'affichage selon la revendication 6, comprenant en outre une couche d'encapsulation (EN) sur le dispositif électroluminescent organique,
dans lequel la couche d'encapsulation (EN) comprend un premier film inorganique (EN1), un film organique (EN2) sur le premier film inorganique (EN1), et un deuxième film inorganique (EN3).

8. Dispositif d'affichage selon la revendication 7, dans lequel la zone de non affichage (NDA1, NDA2) comprend une zone dans laquelle est prévue la partie de court-circuit en matériau organique (PT), et une zone de barrage adjacente à ladite zone.

9. Dispositif d'affichage selon la revendication 8, dans lequel la partie de court-circuit en matériau organique (PT) est prévue en plusieurs quantités, et
les plusieurs parties de court-circuit en matériau organique (PT) comprennent une première partie de court-circuit en matériau organique (PT) positionnée entre la zone d'affichage (DA) et la zone de barrage, et une deuxième partie de court-circuit en matériau organique (PT) positionnée entre la zone de barrage et le trou de capteur (SH).

10. Dispositif d'affichage selon la revendication 9, dans lequel la couche organique (OL) est positionnée à l'extérieur de la zone de barrage dans une vue en plan, et
le premier film inorganique (EN1) et le deuxième film inorganique (EN3) sont en contact l'un avec l'autre dans la zone de barrage et la deuxième partie de court-circuitage en matériau organique (PT).

11. Dispositif d'affichage selon la revendication 10, dans lequel le premier film inorganique (EN1) est en contact direct avec les surfaces supérieure et latérales du motif organique (P3),
dans lequel, de préférence, le premier film inorganique (EN1) est en contact direct avec une surface latérale du motif en contre-dépouille (P1) et une surface inférieure du motif organique (P3).

12. Dispositif d'affichage selon l'une quelconque des revendications 1 à 11, dans lequel le motif inorganique (P2) est en contact direct avec une surface supérieure du motif en contre-dépouille (P1), et/ou
dans lequel le motif en contre-dépouille (P1) comprend une pluralité de couches.
